(19) Europäisches Patentamt
European Patent Office
Office européen des brevets

(11) EP 1 486 802 A1

(12) EUROPEAN PATENT APPLICATION

(43) Date of publication:
15.12.2004 Bulletin 2004/51

(51) Int Cl.7: G02B 5/04, G02F 1/1335

(21) Application number: 04013493.4

(22) Date of filing: 08.06.2004

(84) Designated Contracting States:
AT BE BG CH CY CZ DE DK EE ES FI FR GB GR
HU IE IT LI LU MC NL PL PT RO SE SI SK TR
Designated Extension States:
AL HR LT LV MK

(30) Priority: 09.06.2003 JP 2003164309
11.06.2003 JP 2003166721
04.08.2003 JP 2003205771

(71) Applicant: Kabushiki Kaisha Toyota Jidoshokki
Kariya-shi, Aichi-ken (JP)

(72) Inventors:
• Yoshida, Mikio
Kabushiki Kaisha Toyota Jidoshokki
Aichi-ken (JP)

• Tsuzuki, Toshihiko Kabushiki Kaisha Toyota
Aichi-ken (JP)
• Ishikawa, Haruyuki Kabushiki Kaisha Toyota
Aichi-ken (JP)
• Takeuchi, Norihito Kabushiki Kaisha Toyota
Aichi-ken (JP)

(74) Representative:
Leson, Thomas Johannes Alois, Dipl.-Ing.
Tiedtke-Bühling-Kinne & Partner GbR,
TBK-Patent,
Bavariaring 4
80336 München (DE)

(54) **Textured optical path converting element and display backlight incorporating same**

(57)     An optical device has an incident surface and a light exit surface located at an opposite side from the incident surface. The light exit surface defines a plurality of projections. The projections project away from the incident surface. Sections of the light exit surface that define projections include side faces of pyramids. Each of the pyramids has a bottom that is an imaginary plane substantially parallel to the incident surface. The side faces of each pyramid are slopes. At least one of the slopes is inclined at a range greater than 17° and less than 60° relative to the normal to the incident surface.

**Fig.1**

EP 1 486 802 A1

## EP 1 486 802 A1

**Description**

BACKGROUND OF THE INVENTION

The present invention relates to an optical device that converts the advancing direction of light emitted by an area light emitting device, an area light apparatus that includes the optical device and the area light emitting device, and a display that uses the area light apparatus as a backlight.

For example, Japanese Laid-Open Patent Publication No. 4-67016 discloses a light apparatus 1000 shown in Fig. 17. The light apparatus 1000 includes a light source 100, which is a fluorescent tube, a reflector box 200 the inner surface of which is specular or white, an opaline diffusion plate 300, a transparent prism sheet 400 functioning as an optical device, and a transmissive display panel 500. The prism sheet 400 has on a side triangle pole shaped prisms arranged parallel to one another.

Light emitted from the light source 100 either directly reaches the diffusion plate 300 or reaches the diffusion plate 300 after being reflected by the inner surfaces of the reflector box 200. The light is then converted into a uniform area light by the diffusion plate 300. After light passes through the diffusion plate 300, components of the light that are diffused in the vertical direction are gathered by the prism sheet 400 in a direction of the normal to the display surface of the display panel 500, and reach the display panel 500. Therefore, compared to a case where no prism sheet 400 is provided, a greater amount of light reaches the display panel in a frontward direction, which permits an image having a high brightness to be displayed.

Since the prism sheet 400 gathers light and changes the paths of light only linearly, there have been proposed techniques for two-dimensionally gathering light and changing paths of light.

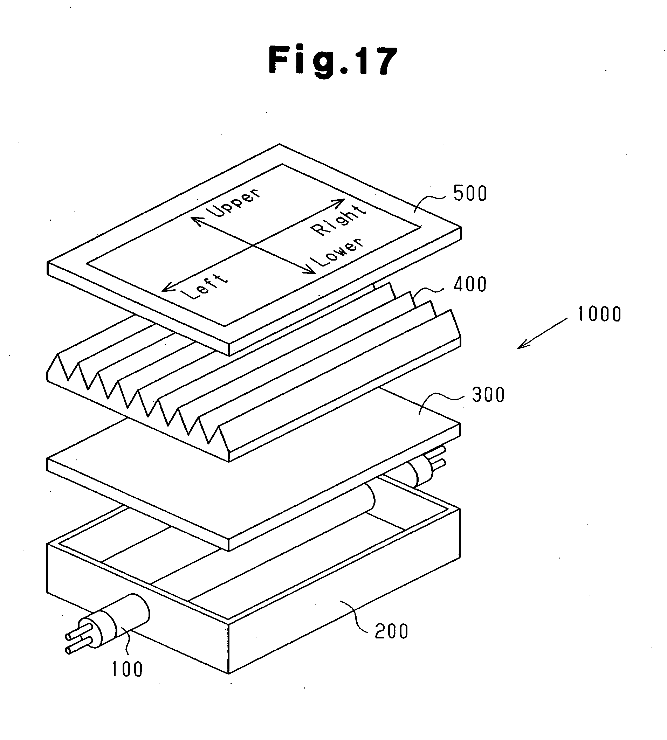

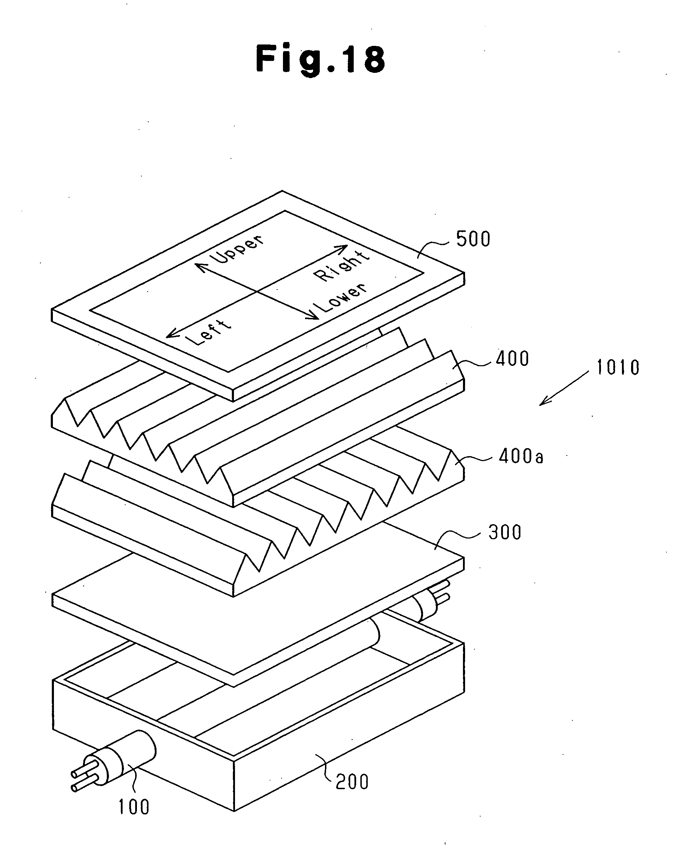

For example, a display 1010 shown in Fig. 18 has, in addition to the configuration of the light apparatus 1000 of Fig. 17, another prism sheet 400a located between the prism sheet 400 and the diffusion plate 300. The prisms on the prism sheet 400a extend in a direction orthogonal to the prisms on the prism sheet 400. In the light that exits the diffusion plate 300 (diffused light), light components in one direction (left-right direction as viewed in the drawing) are gathered by the lower prism sheet 400a, and light components in a direction perpendicular to the left-and-right direction (up-down direction as viewed in the drawing) are gathered by the upper prism sheet 400.

The components of light produced by the light source 100 are two-dimensionally gathered and reach the display panel 500. Accordingly, compared to the light apparatus 1000 shown in Fig. 17, a greater amount of light is gathered in a specific direction (a direction of the normal to the display panel 500), which further increases the brightness of the display.

However, since the display 1010 of Fig. 18 requires the two prism sheets 400, 400a, the display 1010 has a greater thickness a greater number of components than the light apparatus 1000 of Fig. 17. This makes the design and production difficult.

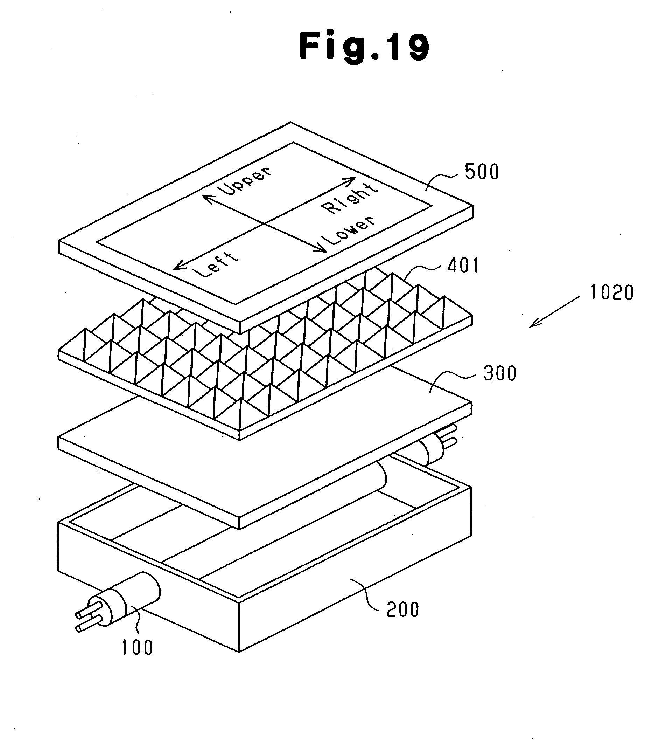

Japanese Laid-Open Patent Publication No. 6-308485 discloses a display 1020 having a single prism sheet 401 as shown in Fig. 19. The prism sheet 401 two-dimensionally gathers light. The display 1020 includes the light source 100, the reflector box 200, the diffusion plate 300, the display panel 500, and the prism sheet 401. The prism sheet 401 is located between the diffusion plate 300 and the display panel 500. On one side of the prism sheet 401, square pyramid shaped prisms are arranged in a grid pattern.

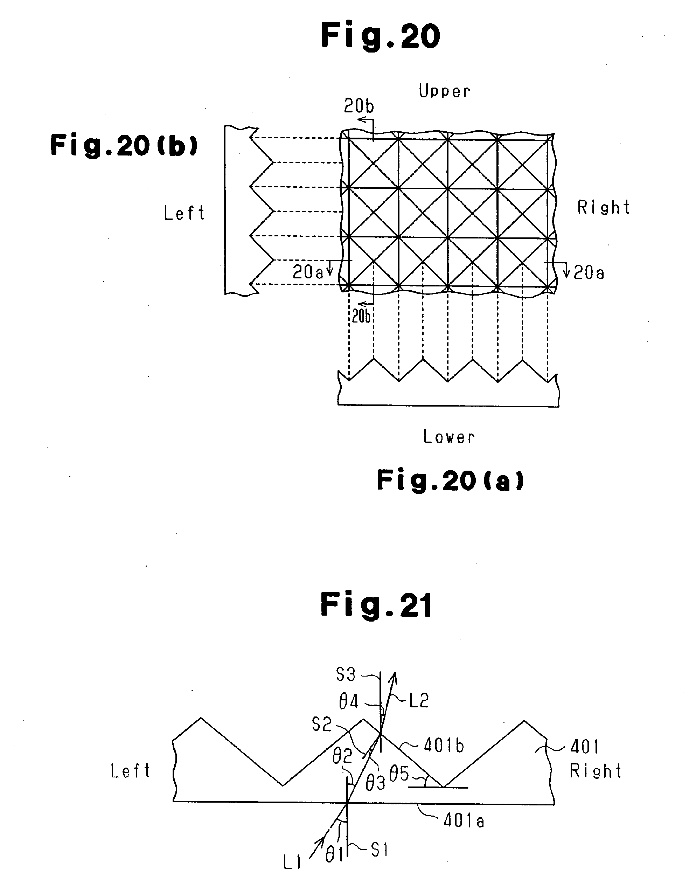

Fig. 20 is a partial front view showing the prism sheet 401 of Fig. 19. Figs. 20a and 20b are cross-sectional views of the prism sheet 401 taken along lines 20a-20a and 20b-20b, respectively.

The shape of the square pyramid of each prism on the prism sheet 401 is designed based only on components of light that enter the prism sheet 401 through an incident surface and are emitted without being reflected. Fig. 21 shows the path of light in the prism sheet 401 in Fig. 20a. As shown in Fig. 21, each of slopes 401b forming the pyramids is designed to be inclined by an angle θ5 (prism angle θ5) with respect to a plane parallel to a plane 401a, which is an incident surface, based on Snell laws of refraction represented by the following equations (formula 1).

$$\theta 2 = \sin^{-1}(\sin\theta 1/n1) \text{ (n1 is the index of refraction of}$$

$$\text{the prism sheet)}$$

$$\theta 3 = \theta 5 - \theta 2$$

$$\theta 4 = \theta 5 - \sin^{-1}(n1 \cdot \sin\theta 2)$$
$$= \theta 5 - \sin^{-1}[n1 \cdot \sin\{\theta 5 - \sin^{-1}(\sin\theta 1/n1)\}]$$

(Formula 1)

In Fig. 21, a ray L1 enters the prism sheet 401 from the air (index of refraction no = 1) at an angle θ1 with respect to the normal S1 to the plane 401a. The ray L1 is refracted at the interface between the air and the plane 401a at an angle θ2, then advances through the prism sheet 401. The ray L1 reaches a prism plane 401b at an angle θ3 with respect to the normal S2 to the prism plane 401b, and is refracted at an angle θ4 with respect to a line S3 that is parallel to the normal S1 to the plane 401a. The light L1 then exits into the air.

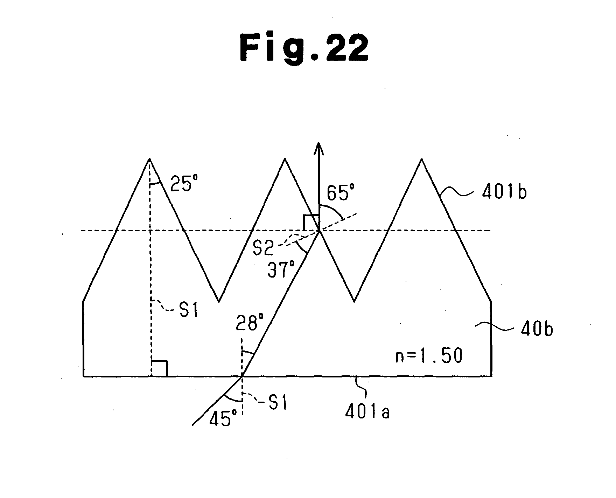

For example, if the index of refraction of the prism sheet 401 is 1.50 and the ray L1 reaches the plane 401a at an angle (incidence angle) θ1 of 45°, the angle of the slope 401b is computed by substituting these values into the formula 1. As shown in Fig. 22, the angle of the slope 401b is 25° with respect to the normal S1 to the plane 401a.

For example, when prism sheets of the indexes of refraction of the following list are employed, the angle of the slope 401b with respect to the normal S1 to the plane 401a are set as shown below.

When the index of refraction is 1.40, the angle of the slope 401b is set to 17°.

When the index of refraction is 1.45, the angle of the slope 401b is set to 20.5°.

When the index of refraction is 1.60, the angle of the slope 401b is set to 32°.

When the index of refraction is 1.64, the angle of the slope 401b is set to 34°.

When the index of refraction is 1.70, the angle of the slope 401b is set to 37.5°.

On the other hand, materials for optical devices such as prism sheets are typically selected in terms of transparency, workability, and weight. For example, materials for optical devices include polymethyl-methacrylate (index of refraction n = 1.49), Arton (n = 1.51, registered trademark), Zeonor (n = 1.52, registered trademark), glass (n = 1.53), polyvinyl chloride (n = 1.54), polyethylene terephthalate (n =1.57), polycarbonate (n = 1.58), polystyrene (n = 1.59). Alternatively, members formed by coating these materials may be employed. The index of refraction of applicable material is in a range between 1.40 and 1.70, inclusive.

Therefore, if a prism sheet is designed using the above formula 1 without considering properties such as reflection properties, although depending on the type of the employed material, the angle of each of the slopes forming the pyramids (projections) with respect to the normal to an incident surface is in a range between 17° and 37.5°, inclusive.

The inventors of the present invention performed simulations using an organic electroluminescent device having an isotropic light emission property and a reflection property as a light source, and found out that, if a prism sheet is formed according to a design using the above formula 1, the brightness cannot be sufficiently increased. The reason for this is considered that some of light that enters the prism sheet was reflected in the prism sheet toward the light source and reached the light source, and this portion of light was reflected by the reflector plate of the light source toward the prism sheet and re-entered the prism sheet.

SUMMARY OF THE INVENTION

A first objective of the present invention is to provide an optical device that has an improved optical properties compared to conventional optical devices.

A second objective of the present invention is to provide an optical device that is different from the optical device shown in the prior art section and has the same or superior characteristics as that of the prior art optical devices.

A third objective of the present invention is to provide a light apparatus having such an optical device.

A forth objective of the present invention is to provide a display having such a light apparatus as a backlight.

To attain the above object, the present invention provides an optical device for changing an optical path of light that reaches the device. The optical device is transparent. The optical device has an incident surface and a light exit surface located at an opposite side from the incident surface. The light exit surface defines a plurality of projections and/or recesses. The projections project away from the incident surface. The recesses are dented toward the incident surface. Sections of the light exit surface that define projections and/or recesses include side faces of pyramids or truncated pyramids. Each of the pyramids and the truncated pyramids has a bottom that is an imaginary plane substantially parallel to the incident surface. The side faces of each of the pyramids and the truncated pyramids are slopes. At least one of the slopes is inclined at a predetermined angle relative to the normal to the incident surface. The predetermined angle is in a range greater than 17° and less than 60°.

In this embodiment, slopes refer to slopes of a pyramid and do not include the bottom of the pyramid. Each slope is triangular.

The present invention also provides an optical device for changing an optical path of light that reaches the device. The optical device is transparent. The optical device has an incident surface and a light exit surface located at an opposite side from the incident surface. The light exit surface defines a plurality of projections and/or recesses. The projections project away from the incident surface. The recesses are dented toward the incident surface. Sections of the light exit surface that define projections and/or recesses include side faces of cones or truncated cones. Each of the cones and the truncated cones has a bottom that is an imaginary plane substantially parallel to the incident surface. The side face of each cone or each truncated cone is inclined at a predetermined angle relative to the normal to the incident surface. The predetermined angle is in a range greater than 30° and less than 55°.

The side surface of a cone refers to the surface of the cone except for the bottom.

Other aspects and advantages of the invention will become apparent from the following description, taken in conjunction with the accompanying drawings, illustrating by way of example the principles of the invention.

BRIEF DESCRIPTION OF THE DRAWINGS

The invention, together with objects and advantages thereof, may best be understood by reference to the following description of the presently preferred embodiments together with the accompanying drawings in which:

Fig. 1 is an exploded perspective view illustrating a first area light apparatus according to one embodiment of the present invention;
Fig. 2 is a plan view for explaining the structure of the first prism sheet in the first area light apparatus;
Fig. 2(a) is a cross-sectional view taken along line 2a-2a of Fig. 2;
Fig. 2(b) is a cross-sectional view taken along line 2b-2b of Fig. 2;
Fig. 3 is a plan view illustrating another prism sheet according to the embodiment of Fig. 1;
Fig. 3(a) is a cross-sectional view taken along line 3a-3a of Fig. 3;
Fig. 3(b) is a cross-sectional view taken along line 3b-3b of Fig. 3;
Fig. 4 is an exploded perspective view illustrating a prior art area light apparatus;
Fig. 5 is an exploded perspective view a prior art area light apparatus that is different from the area light apparatus shown in Fig. 4;
Fig. 6 is a cross-sectional view illustrating a first prism sheet according to a modification;
Fig. 7 is a graph showing the relative ratio of brightness when the area of a upper surface relative to the area of a bottom is changed in an area light apparatus having the prism sheet shown in Fig. 6;
Fig. 8 is a plan view showing a first prism sheet according to a modification;
Fig. 8(a) is a cross-sectional view taken along line 8a-8a of Fig. 8;
Fig. 8(b) is a cross-sectional view taken along line 8b-8b of Fig. 8;
Fig. 9 is a plan view showing a first prism sheet according to a modification;
Fig. 9(a) is a cross-sectional view taken along line 9a-9a of Fig. 9;
Fig. 9(b) is a cross-sectional view taken along line 9b-9b of Fig. 9;
Fig. 10 is a plan view showing a first prism sheet according to a modification;
Fig. 10(a) is a cross-sectional view taken along line 10a-10a of Fig. 10;
Fig. 10(b) is a cross-sectional view taken along line 10b-10b of Fig. 10;
Fig. 11 is a plan view illustrating a second prism sheet in a second area light apparatus;
Fig. 11(a) is a cross-sectional view taken along line 11a-11a of Fig. 11;
Fig. 11(b) is a cross-sectional view taken along line 11b-11b of Fig. 11;
Fig. 12 is a plan view showing another prism sheet according to a modification;
Fig. 12(a) is a cross-sectional view taken along line 12a-12a of Fig. 12;
Fig. 12(b) is a cross-sectional view taken along line 12b-12b of Fig. 12;
Fig. 13 is a first diagram for explaining extraction of light in the prism sheet according to the first embodiment;
Figs. 14(a) and 14(b) are second diagrams for explaining extraction of light in the prism sheet according to the first embodiment;
Figs. 15(a) and 15(b) are third diagrams for explaining extraction of light in the prism sheet according to the first embodiment;
Figs. 16(a) and 16(b) are fourth diagrams for explaining extraction of light in the prism sheet according to the first embodiment;
Fig. 17 is an exploded perspective view illustrating a prior art display;
Fig. 18 is an exploded perspective view illustrating another prior art display;
Fig. 19 is an exploded perspective view illustrating another prior art display;
Fig. 20 is a plan view showing the prism sheet in the display of Fig. 19;
Fig. 20(a) is a cross-sectional view taken along line 20a-20a of Fig. 20;

Fig. 20(b) is a cross-sectional view taken along line 20b-20b of Fig. 20;

Fig. 21 is a cross-sectional view showing the path of light in the prism sheet of Fig. 20 based on Snell laws of refraction; and

Fig. 22 is a cross-sectional view showing the path of light in the prism sheet of Fig. 20 based on Snell laws of refraction.

## DETAILED DESCRIPTION OF THE PREFERRED EMBODIMENTS

Several embodiments of the present invention will now be described with reference to the drawings. Like or the same reference numerals are given to those components that are like or the same in the drawings. A first area light apparatus 101 will now be described.

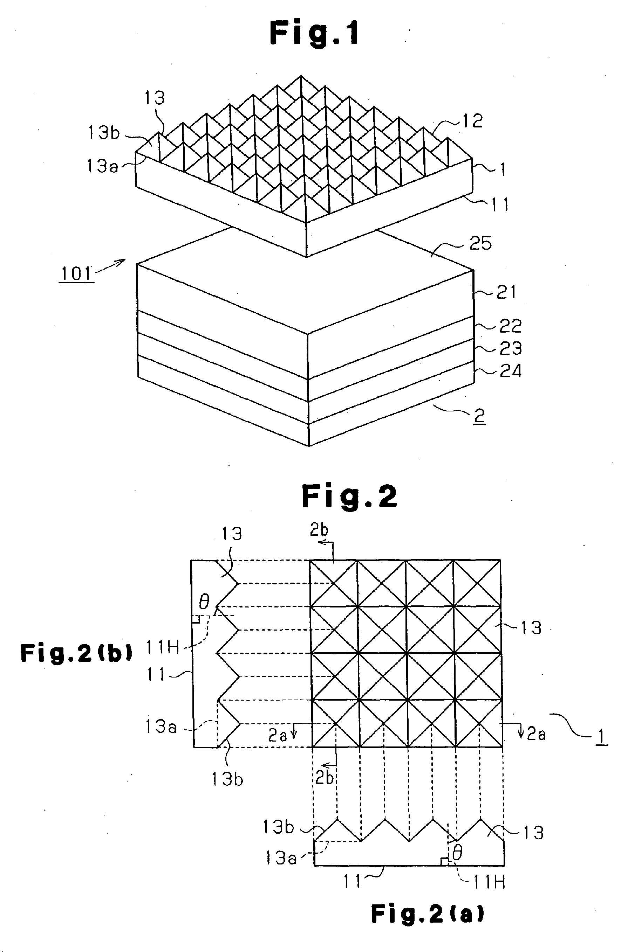

As shown in Fig. 1, the first area light apparatus 101 includes an optical device, which is a prism sheet 1, and an area light-emitting device, which is an organic electroluminescent device (organic EL device) 2.

The organic EL device 2 has a transparent substrate and is formed by consecutively laminating a transparent electrode 22, an organic layer 23, and a reflecting electrode 24 on the transparent substrate 21. The transparent substrate 21 is formed, for example, of glass or an acrylic resin. The transparent electrode 22 is formed, for example, of ITO. The organic layer 23 contains organic light-emitting material such as Alq3 and Ir(ppy)3. The reflecting electrode 24 is formed, for example, of Al.

When a current is supplied between the transparent electrode 22 and the reflecting electrode 24, recombination of holes and electrons occurs, which generates excitons. Accordingly, the organic light-emitting material is excited. Then, when returning to the ground state, the excited organic light-emitting material emits light. The organic EL device 2 has an isotropic light emission property. That is, light generated at the organic light-emitting material is directed to all the directions.

The reflecting electrode 24 reflects light directed from the organic layer 23 to the reflecting electrode 24 and light that has been reflected by the prism sheet 1 and reaches the organic EL device 2 toward the prism sheet 1. The reflecting electrode 24 provides the organic EL device 2 with a reflection property.

The prism sheet 1 has an incident surface 11 and a light exit surface 12 located at an opposite side from the incident surface 11. The organic EL device 2 has the light extracting surface 25, which is a surface of the transparent substrate 21 that faces the incident surface 11. The light extracting surface 25 and the incident surface 11 are arranged to be parallel to each other.

In this specification, isotropic light emission property refers to a property in which the brightness in the same direction with respect to the normal to a light extracting surface of an area light-emitting device is substantially uniform. The reflection property refers to a property in which light from an optical device is reflected back to the optical device.

The isotropic light emission property of the organic EL element 2 is preferably designed such that the number of luminous fluxes in a range between 30° and 60°, inclusive, more preferably, in a range between 40° and 50°, inclusive, and most preferably, in a range about 45° with respect to the normal to a light extracting surface 25 is the greatest compared to the amount of light in other directions. Such a device is formed by properly designing and selecting the shape of the substrate, thickness of each layer, and the materials of the organic EL element 2.

The light exit surface 12 of the prism sheet 1 defines square pyramid shaped projections 13, which project away from the incident surface 11. A section of the light exit surface 12 that defines each projection 13 includes side faces of the corresponding pyramid. The bottom of each pyramid has a bottom 13a, which is an imaginary plane substantially parallel to the incident plane 11. The side faces are formed with slopes 13b. In this embodiment, the bottom 13a of each projection 13 is substantially square, and is located in an imaginary plane that lies substantially parallel to the incident surface 11. The slopes 13b of each projection 13 form part of the light exit surface 12.

The imaginary plane contains the points and sides forming the bottom of each projection 13. The prism sheet 1 may be configured such that an imaginary plane that contains the bottom of at least one of the projections 13 may be displaced from the imaginary plane that contains the bottoms of the other projections 13.

The inventors of the present invention performed ray tracking simulations by Monte Carlo method. Through the simulations, the inventors computed changes of front brightness of the first area light apparatus (the brightness in a direction of the normal to the incident surface 11) when the angle of slopes 13b of the projections 13 were varied. The conditions of the simulations are shown below.

In this specification, the angle defined by the normal and each slope 13b refers to the smallest angle in the angles defined by the normal and lines on the slope 13b. In this embodiment, the angle defined by the normal and each slope 13b refers to an angle defined by the normal to the incident surface 11 and a line in the slope 13b that includes the peak of the slope 13b, or the peak of the corresponding pyramid, and perpendicularly intersects the corresponding bottom 13a.

<Example 1>

The organic EL device 2 and the prism sheet 1 are square plates each side of which is 5 cm long.

The distance between the light extracting surface 25 and the incident surface 11 is 10 μm.

The distance between the light extracting surface 25 and the reflecting electrode 24 is 500 μm.

A square plane that is away from the peak of each projection 13 by 10 μm and parallel to the light extracting surface 25 is set as a measurement plane. The sides of the measurement plane is 5 cm long each.

When projected onto a plane containing the light extracting surface 25, the shape of the measurement plane and the shape of the prism sheet 1 match the shape of the light extracting surface 25.

The measurement plane has one million rays.

The projections 13 have identical shapes. Each bottom 13a of each projection 13 is 100 μm long.

The index of refraction of the prism sheet 1 is 1.50.

Each bottom 13a is common to the corresponding adjacent pair of projections 13 (pyramids). However, the outer bottom 13a of each outermost projection 13 is not common to any other projections 13.

In Fig. 2, an angle defined by each slope 13b of the projections 13 and the normal 11H to the incident surface 11 is referred to as an angle θ. The brightness in a direction of the normal 11H to the incident surface 11, or the front brightness, was simulated while varying the angle θ as shown in Table 1.

The results are shown in Table 1. In Table 1, the brightness is expressed as a front brightness ratio (brightness ratio) with respect to the brightness in a direction of the normal to the light extracting surface 25 of the organic EL device 2, that is, with respect to the front brightness.

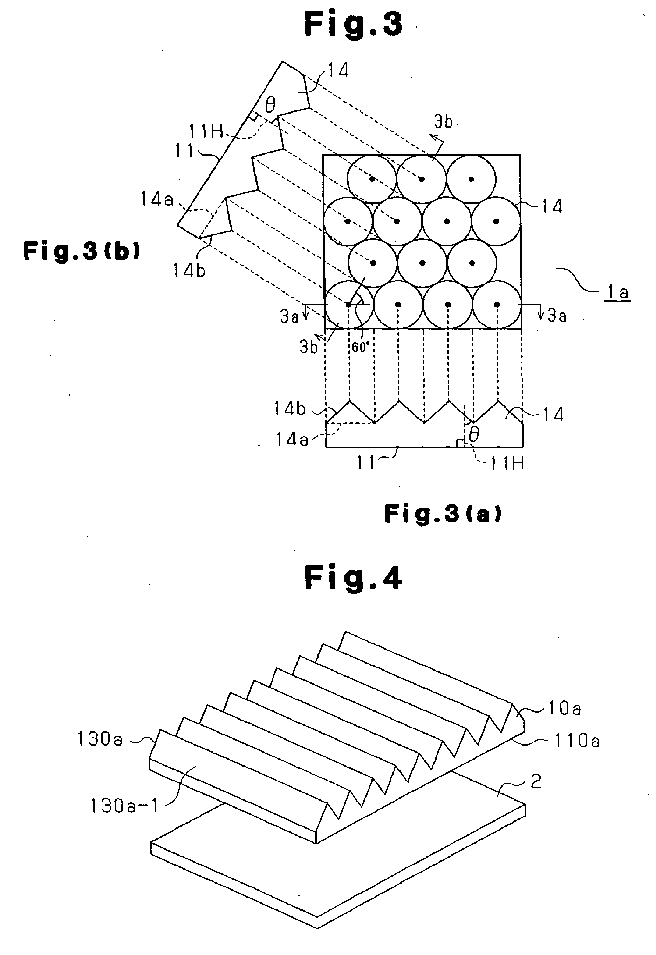

A first prism sheet 1a shown in Fig. 3 is a modifications of the first prism sheet 1 shown in Fig. 2. The first prism sheet 1a has cone shaped projections 14. Each projection 14 has a circular bottom 14a the diameter of which is 100 μm. The projections 14 are arranged such that each adjacent pair of the bottoms 14a contact each other. The projections 14 are arranged in a hexagonal closest packed structure. The other configurations are the same as those of the first area light apparatus shown in Fig. 1. Regarding the first prism sheet 1a, an angle defined by each slope 14b of the projections 14 and the normal 11H to the incident surface 11 was varied as shown in Table 2 below, and the brightness in a direction of the normal to the incident surface was simulated.

The results are shown in Table 2. In Table 2 also, the brightness is expressed as the front brightness of the light extracting surface 25 of the organic EL device 2, that is, as a ratio (front brightness ratio) with respect to the front brightness of an area light apparatus that includes only the organic EL device 2.

Table 1:

| Angle θ, Front Brightness Ratio, and Magnitude of Front Brightness Ratio (Proportion) in each Angle θ with respect to Front Brightness Ratio when Angle θ is 45°, in Prism Sheet having Index of Refraction of 1.50 (n = 1.50) | | |
| --- | --- | --- |
| Angle θ (deg) | Front Brightness Ratio | Proportion (%) |
| 5.0 | 0.76 | 45 |
| 10.0 | 0.76 | 45 |
| 15.0 | 0.92 | 54 |
| 20.0 | 1.07 | 63 |
| 25.0 | 1.20 | 71 |
| 30.0 | 1.18 | 70 |
| 35.0 | 1.26 | 75 |
| 40.0 | 1.41 | 83 |
| 42.5 | 1.55 | 92 |
| 43.0 | 1.60 | 95 |
| 43.5 | 1.61 | 95 |
| 44.0 | 1.65 | 98 |
| 44.5 | 1.66 | 98 |
| 45.0 | 1.69 | 100 |
| 45.5 | 1.68 | 99 |

Table 1:  (continued)

| Angle θ, Front Brightness Ratio, and Magnitude of Front Brightness Ratio (Proportion) in each Angle θ with respect to Front Brightness Ratio when Angle θ is 45°, in Prism Sheet having Index of Refraction of 1.50 (n = 1.50) | | |
| --- | --- | --- |
| Angle θ (deg) | Front Brightness Ratio | Proportion (%) |
| 46.0 | 1.65 | 98 |
| 46.5 | 1.57 | 93 |
| 47.5 | 1.43 | 85 |
| 50.0 | 1.34 | 79 |
| 55.0 | 1.10 | 65 |
| 60.0 | 1.01 | 60 |
| 65.0 | 0.98 | 58 |
| 70.0 | 0.98 | 58 |
| 75.0 | 0.98 | 58 |
| 80.0 | 0.98 | 58 |
| 85.0 | 0.99 | 59 |

Table 2:

| Angle θ defined by Slope 14b of Cones and Normal 11H to Incident surface, Front Brightness Ratio, and Magnitude of Front Brightness Ratio (Proportion) in each Angle θ with respect to Front Brightness when Angle θ is 45° | | |
| --- | --- | --- |
| Angle θ (deg) | Front Brightness Ratio | Proportion (%) |
| 10 | 1.05 | 74 |
| 20 | 1.04 | 73 |
| 25 | 1.21 | 85 |
| 30 | 1.31 | 92 |
| 35 | 1.21 | 85 |
| 40 | 1.27 | 89 |
| 42.5 | 1.30 | 92 |
| 44 | 1.37 | 96 |
| 45 | 1.42 | 100 |
| 46 | 1.39 | 98 |
| 47.5 | 1.34 | 95 |
| 50 | 1.31 | 92 |
| 55 | 1.08 | 76 |
| 60 | 1.00 | 71 |
| 70 | 0.97 | 68 |
| 80 | 0.98 | 69 |

(Evaluations)

According to Snell laws of refraction represented by the formula 1, the front brightness is expected to be maximized when the angle defined by each slope 13b of the projections 13 and the normal 11H to the incident surface 11 or the angle defined by each slope 14b of the projections 14 and the normal 11H is 25°. However, as obvious from Tables 1 and 2, regardless whether the projections were shaped as square pyramids or cones, there existed angles at which the front brightness was greater than the case of the slope angle of 25°. That is, the inventors of the present invention found out that at certain angles of slopes of projections, the front brightness is increased to a level that cannot be achieved by conventional optical designs in which reflection property is not taken into consideration. In other words, the inventors found out requirements for prism sheets and area light apparatuses that exert superior optical properties. The evaluations will now be described in more details.

[Evaluation 1]

Referring to Table 1, when the slopes 13b of the projections 13 are formed to satisfy the following requirement (1-1), the front brightness is higher than that in a case of an angle of 25°, where the front brightness is expected to be maximized when a design according to Snell laws without considering the reflection property is applied. That is, when the slope angle was set in any of the following angle ranges, substantially favorable optical properties (the property of changing path of rays and the property for gathering light) were obtained.

(1-1) An angle greater than 30° and less than 55°.
When the angle θ of the slopes 13b of the projections 13 are designed to satisfy any of the following requirements (1-2) to (1-5), the front brightness is greater than the case where the slope angle is 25°. The prism sheet and the area light apparatus according to this embodiment have superior optical properties.
(1-2) An angle in a range no less than 35° and less than 55°.
(1-3) An angle in a range no less than 35° and no more than 50°.
(1-4) An angle in a range greater than 30° and no more than 50°.
(1-5) An angle in a range ±7° with respect to 45°.

(Evaluation 2)

As a comparison example, a commercially available prism sheet 10a shown in Fig. 4 was used. The prism sheet 10a includes an incident surface 110a and triangle pole shaped prisms 130a arranged parallel to one another. Under the conditions of the above simulations, simulations were performed for the front brightness of an area light apparatus that uses the prism sheet 10a. As a result, the front brightness was 1.30. The conditions of the simulations are shown below.
The index of refraction of the prism sheet 10a is 1.60.
The angle of each slope 130a-1 of the triangle pole (prism) with respect to the normal to the incident surface 110a is 45°. The angle of 45° is an angle in Table 1 that is defined by the normal to the incident surface and the slope of the pyramids or cones at which angle the front brightness is maximized.
The conditions other than the ones listed, for example, the light emitting property and the reflection property of the organic EL device 2, were the same as those in the previous simulation.
The comparison between the simulation results of the comparison examples of Fig. 4 and the simulation results of Table 1 shows that setting the range of the angle of the slopes 13b of the projections 13 to satisfy the following requirement (2-1) made the front brightness greater than that of the comparison example of Fig. 4.

(2-1) An angle in a range greater than 35° and less than 55°.
Also, when the angle θ of the slopes 13b of the projections 13 was set to satisfy any of the following requirements (2-2) to (2-5), the prism sheet and the area light apparatus exerted optical properties superior to the comparison example of Fig. 4.
(2-2) An angle in a range greater than 35° and no more than 50°.
(2-3) An angle in a range no less than 40° and less than 55°.
(2-4) An angle in a range no less than 40° and no more than 50°.
(2-5) An angle in a range ±5° with respect to 45°.

(Evaluation 3)

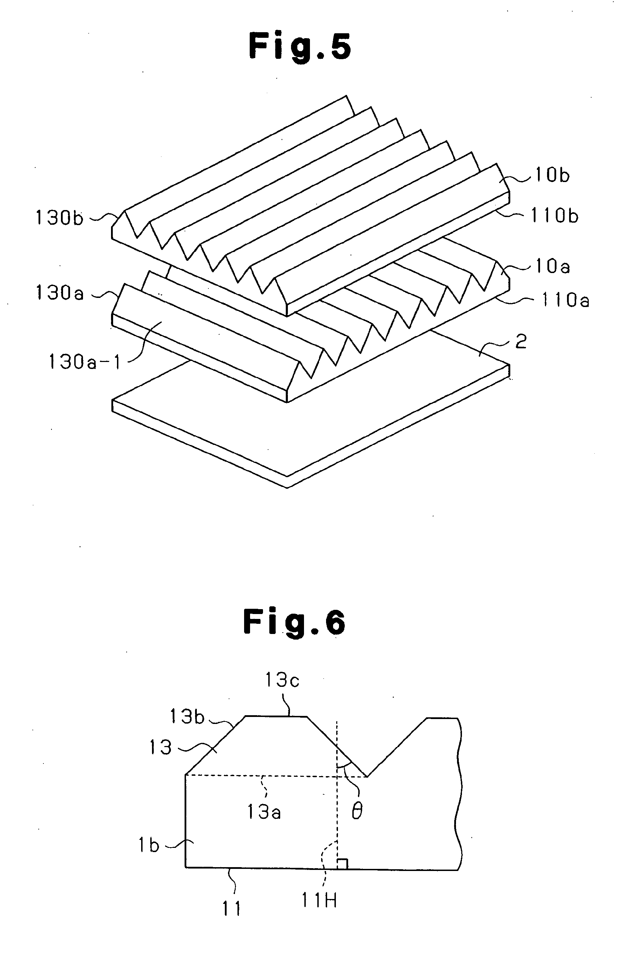

Fig. 5 shows an area light apparatus of another comparison example. The light apparatus of Fig. 5 is formed by stacking two prism sheets 10a, 10b that are the same as the prism sheet shown in Fig. 4 used in Evaluation (2). The prism sheets 10a, 10b have triangle pole shaped prisms 130a, 130b, respectively. The prism sheets 10a, 10b are stacked such that the prisms 130a, 130b lie perpendicular to each other. According to the results of the simulation of Fig. 5, the front brightness was 1.50. Except for the above condition that two sheets are stacked such that the prisms are arranged orthogonal to each other, the other conditions of the simulation were the same as those in the simulation of the comparison example in Evaluation (2).

As obvious from the comparison example and Table 1, in an angle range that satisfies the following requirement (3-1), the first area light apparatus of the present embodiment had a greater front brightness than that of the area light apparatus shown in Fig. 5. That is, when the slope angle was set in the following angle ranges, a light gathering property (optical property) superior to that of conventional apparatuses was obtained.

(3-1) An angle in a range greater than 40° and less than 47.5°.

Also, when the angle θ of the slopes 13b of the projections 13 was set to satisfy any of the following requirements (3-2) to (3-7), the prism sheet and the area light apparatus exerted optical properties superior to the area light apparatus shown of Fig. 5.

(3-2) An angle in a range greater than 40° and no more than 46°.
(3-3) An angle in a range no less than 42.5° and less than 47.5°.
(3-4) An angle in a range no less than 42.5° and no more than 46°.
(3-5) An angle in a range greater than 40° and no more than 46.5°.
(3-6) An angle in a range no less than 42.5° and no more than 46.5°.
(3-7) An angle in a range ±1.5° with respect to 45°.

(Evaluation 4)

As obvious from Tables 1 and 2, a prism sheet in which the slopes 13b of the projections 13 satisfied the following requirement (4-1) had a greater front brightness than a prism sheet having the cone shaped projections 14, in which the angle of the slopes 14b with respect to the normal 11H to the incident surface was the same as that of the slopes 13b. Also, in this case, the prism sheet with the projections 13 had a sufficient optical performance that the front brightness ratio was no less than 1.20. These results are considered to be caused by the fact that square shaped pyramids can be provided more densely on the light exit surface 12 than the cone shaped projections.

(4-1) An angle in a range greater than 30° and less than 55°.

Also, when the angle θ of the slopes 13b of the projections 13 was set to satisfy any of the following requirements (4-2) to (4-4), the prism sheet and the area light apparatus exerted optical properties superior to a prism sheet having the cone shaped projections 14 with the slopes 14b.

(4-2) An angle in a range greater than 30° and no more than 50°.
(4-3) An angle in a range no less than 35° and less than 55°.
(4-4) An angle in a range no less than 35° and no more than 50°.

Also, when the angle θ of the slopes 13b of the projections 13 was set to satisfy any of the following requirements (4-5) to (4-6), the front brightness was greater than a prism sheet having the cone shaped projections 14 with the slopes 14b.

(4-5) An angle in a range greater than 30° and no more than 60°.
(4-6) An angle in a range no less than 35° and no more than 60°.

(Evaluation 5)

As obvious from Tables 1 and 2, when the angle θ of the slopes 13b of the projections 13, which were square pyramids, was set to satisfy the following requirement (5-1), the front brightness ratio was higher than the maximum front brightness ratio of a case when the projections were cone shaped (when the angle of the slopes 14b is 45°). This is considered to be caused by the fact that square shaped pyramids can be provided densely on the light exit surface 12 of the first prism sheet 1.

(5-1) An angle in a range greater than 40° and less than 50°.

Also, when the angle θ of the slopes 13b of the projections 13 was set to satisfy any of the following requirements (5-2) to (5-4), the prism sheet and the area light apparatus exerted superior optical properties as in the above examples.

(5-2) An angle in a range greater than 40° and no more than 47.5°.
(5-3) An angle in a range no less than 42.5° and less than 50°.
(5-4) An angle in a range no less than 42.5° and no more than 47.5°.

(Evaluation 6)

As obvious from Table 1, the prism sheet 1 and the area light apparatus had a significantly superior performance when the angle θ of the projections 13 was 45° compared to the cases where the angle θ had other values. That is, the front brightness ratio of the prism sheet 1 and the area light apparatus was maximized to 1.69 when the angle θ was 45°.

When the angle θ satisfied the following requirement (6-1) or preferably the requirement (6-2), the front brightness of the prism sheet 1 and the area light apparatus was no less than 90% of the case where the angle θ was 45°. That is, the prism sheet 1 and the area light apparatus had substantially the same performance as the case where the angle θ was 45°.

(6-1) An angle in a range ±2.5° with respect to 45°.
(6-2) An angle in a range ±1.5° with respect to 45°.
When the angle θ satisfied the following requirement (6-3) or preferably the requirement (6-4), the front brightness of the prism sheet 1 and the area light apparatus was no less than 80% of the case where the angle θ was 45°. That is, the prism sheet 1 and the area light apparatus had the substantially same performance as the case where the angle θ was 45°.
(6-3) An angle in a range ±5° with respect to 45°.
(6-4) An angle in a range ±2.5° with respect to 45°.

The first area light apparatus 101 and the prism sheet 1 shown in Fig. 1 can be formed by a conventional process.

The organic EL device 2 can be formed by a film forming process used for forming conventional organic EL device. That is, the organic EL device 2 is formed by properly laminating materials used in conventional organic EL device.

The first prism sheet 1 can be formed by pouring a material such as glass or resin into a mold in which pyramids are carved and solidifying the material. The first prism sheet 1 can also be formed by a conventional patterning process in which patterns are formed on a glass or resin material. Further, the first prism sheet 1 can be formed by carving the projections 13 on a transparent plate.

The organic EL device 2 and the first prism sheet 1 can be attached to each other by conventional assembling process or assembling members for area light apparatuses.

The first prism sheet 1 has the square pyramids having slopes in one of the above described angle ranges on a side opposite from the incident surface 11. The square pyramids densely and entirely cover the surface. Therefore, the brightness in a specific direction is significantly increased.

Particularly, in this embodiment, the paths of light generated by an area light-emitting device that has an isotropic light-emitting property and a reflection property are effectively converted into a specific direction (in this specification, the front direction). That is, in this embodiment, unlike the conventional prism sheets 10a, 10b, 400, 400a, 401 shown in Figs. 4, 5, and 17 to 22, which are formed without considering the reflection property, highly improved optical properties such as the light gathering property are obtained.

Also, the first area light apparatus 101 having the first prism sheet 1 has a higher brightness in a specific direction, for example, in a direction of the normal to the incident surface 11 (the front direction) than an area light apparatus having a prism sheet that is designed without considering the reflection property.

Under the conditions of the above simulations, simulations were performed for a case where the index of refraction of the prism sheet is 1.50. As in the previous simulations, the prism sheet of this embodiment, which had a greater value of the angle θ than a conventional prism sheet, had a superior optical properties. The specific measurement results are shown below.

<Example 2>

In Example 2, the area light apparatus was designed to be the same as that of Example 1, except that the index of refraction of the first prism sheet 1 was set to 1.4, and optical simulations were performed under the above conditions. The results are shown in Table 3.

Table 3:

| Angle θ, Front Brightness Ratio, and Magnitude of Front Brightness Ratio (Proportion) in each Angle θ with respect to Front Brightness Ratio when Angle θ is 45°, in Prism Sheet having Index of Refraction of 1.40 (n = 1.40) | | |
|---|---|---|
| Angle θ (deg) | Front Brightness Ratio | Proportion (%) |
| 17.0 | 0.70 | 49 |
| 20.0 | 0.96 | 67 |

Table 3: (continued)

| Angle θ, Front Brightness Ratio, and Magnitude of Front Brightness Ratio (Proportion) in each Angle θ with respect to Front Brightness Ratio when Angle θ is 45°, in Prism Sheet having Index of Refraction of 1.40 (n = 1.40) | | |
|---|---|---|
| Angle θ (deg) | Front Brightness Ratio | Proportion (%) |
| 25.0 | 1.27 | 88 |
| 30.0 | 1.25 | 87 |
| 32.5 | 1.26 | 88 |
| 35.0 | 1.31 | 91 |
| 40.0 | 1.32 | 92 |
| 42.5 | 1.33 | 92 |
| 43.0 | 1.34 | 93 |
| 43.5 | 1.38 | 96 |
| 44.0 | 1.38 | 96 |
| 44.5 | 1.40 | 97 |
| 45.0 | 1.44 | 100 |
| 45.5 | 1.38 | 96 |
| 46.0 | 1.34 | 93 |
| 46.5 | 1.31 | 91 |
| 47.0 | 1.27 | 88 |
| 47.5 | 1.23 | 85 |
| 50.0 | 1.07 | 74 |
| 51.0 | 1.20 | 83 |
| 52.5 | 1.13 | 78 |
| 55.0 | 1.05 | 73 |
| 60.0 | 0.99 | 69 |

(Evaluation)

As obvious from Table 3, even when the prism sheet had an index of refraction of 1.4, the front brightness was higher in some angles than the case when the angle θ was set to 17° without considering the reflection property. That is, the inventors of the present invention found out configurations for prism sheets and area light apparatuses having superior optical properties that cannot be achieved by conventional optical designs in which the reflection property is not taken into consideration. The evaluations will now be described in more details.

(Evaluation 7)

When the range of the angle θ was set to satisfy the following requirement (7-1), the front brightness ratio was higher than that of a prism sheet and an area light apparatus that were designed to have the angle θ of 17° without taking the reflection property into consideration.

(7-1) An angle in a range greater than 17° and less than 60°.
When the range of the angle θ was set to satisfy any of the following requirements (7-2) to (7-3), the front brightness ratio was higher than that of a prism sheet and an area light apparatus that were designed without taking the reflection properties into consideration.

(7-2) An angle in a range no less than 20° and less than 60°.

(7-3) An angle in a range ±15° with respect to 45°.

(Evaluation 8)

When the range of the angle θ was set to satisfy the following requirement (8-1), the front brightness was higher than 1.30, which was the front brightness ratio of the area light apparatus of Evaluation (2), which used a commercially available prism sheet.

(8-1) An angle in a range greater than 32.5° and less than 47°.
When the range of the angle θ was set to satisfy any of the following requirements (8-2) to (8-5), the front brightness ratio was no less than 1.30.
(8-2) An angle in a range greater than 32.5° and no more than 46.5°.
(8-3) An angle in a range no less than 35° and less than 47°.
(8-4) An angle in a range no less than 35° and no more than 46.5°.
(8-5) An angle in a range ±1.5° with respect to 45°.

(Evaluation 9)

As obvious from Table 3, the prism sheet and the area light apparatus had a significantly superior performance when the angle θ was 45° compared to the cases where the angle θ had other values. That is, the front brightness ratio of the prism sheet and the area light apparatus was 1.44 when the angle θ was 45°.
When the angle θ satisfied the following requirement (9-1) or preferably the requirement (9-2), the front brightness of the prism sheet 1 and the area light apparatus was no less than 90% of the case where the angle θ was 45°. That is, the prism sheet 1 and the area light apparatus had substantially the same performance as the case where the angle θ was 45°.

(9-1) An angle in a range ±5° with respect to 45°.
(9-2) An angle in a range ±1.5° with respect to 45°.
When the angle θ satisfied the following requirement (9-3) or preferably the requirement (9-4), the front brightness of the prism sheet 1 and the area light apparatus was no less than 80% of the case where the angle θ was 45°. That is, the prism sheet 1 and the area light apparatus had the substantially same performance as the case where the angle θ was 45°.
(9-3) An angle in a range ±10° with respect to 45°.
(9-4) An angle in a range ±2.5° with respect to 45°.

Further, when the angle θ was approximately 51°, the prism sheet 1 and the area light apparatus had a performance in which the front brightness ratio was no less than 80% of that of the case where the angle θ was 45°. Also, when the angle θ was more than 47.5° and less than 60°, the prism sheet 1 and the area light apparatus had a performance in which the front brightness ratio was no less than 70% of that of the case where the angle θ was 45°.

<Example 3>

In Example 3, the area light apparatus was designed to be the same as that of Example 1, except that the index of refraction of the first prism sheet 1 was set to 1.45, and optical simulations were performed under the above conditions. The results are shown in Table 4.

Table 4:

| Angle θ, Front Brightness Ratio, and Magnitude of Front Brightness Ratio (Proportion) in each Angle θ with respect to Front Brightness Ratio when Angle θ is 45°, in Prism Sheet having Index of Refraction of 1.45 (n = 1.45) | | |
| --- | --- | --- |
| Angle θ (deg) | Front Brightness Ratio | Proportion (%) |
| 17.5 | 0.83 | 51 |
| 20.5 | 1.03 | 64 |
| 25.0 | 1.19 | 73 |
| 30.0 | 1.18 | 73 |

Table 4: (continued)

| Angle θ, Front Brightness Ratio, and Magnitude of Front Brightness Ratio (Proportion) in each Angle θ with respect to Front Brightness Ratio when Angle θ is 45°, in Prism Sheet having Index of Refraction of 1.45 (n = 1.45) | | |
| --- | --- | --- |
| Angle θ (deg) | Front Brightness Ratio | Proportion (%) |
| 32.5 | 1.23 | 76 |
| 35.0 | 1.29 | 80 |
| 40.0 | 1.37 | 85 |
| 42.5 | 1.43 | 88 |
| 43.0 | 1.46 | 90 |
| 43.5 | 1.48 | 91 |
| 44.0 | 1.57 | 97 |
| 44.5 | 1.60 | 99 |
| 45.0 | 1.62 | 100 |
| 45.5 | 1.54 | 95 |
| 46.0 | 1.49 | 92 |
| 46.5 | 1.47 | 91 |
| 47.0 | 1.35 | 83 |
| 47.5 | 1.30 | 80 |
| 50.0 | 1.07 | 66 |
| 55.0 | 1.03 | 64 |
| 60.0 | 0.91 | 56 |

(Evaluation)

As obvious from Table 4, even when the prism sheet had an the index of refraction of 1.45, the front brightness was higher in some angles than the case when the angle θ was set to 20.5° without considering the reflection property. That is, the inventors of the present invention found out configurations for prism sheets and area light apparatuses having superior optical properties that cannot be achieved by conventional optical designs in which the reflection property is not taken into consideration. The evaluations will now be described in more details.

(Evaluation 10)

When the range of the angle θ was set to satisfy the following requirement (10-1), the front brightness ratio was higher than or equal to that of a prism sheet and an area light apparatus having the angle θ of 20.5°.

(10-1) An angle in a range greater than 20.5° and less than 60°.
    When the range of the angle θ was set to satisfy any of the following requirements (10-2) to (10-5), the front brightness ratio was higher than or equal to that of a prism sheet and an area light apparatus that were designed without taking the reflection properties into consideration.
(10-2) An angle in a range no less than 25° and less than 60°.
(10-3) An angle in a range greater than 20.5° and no more than 55°.
(10-4) An angle in a range no less than 25° and no more than 55°.
(10-5) An angle in a range ±10° with respect to 45°.
    When the range of the angle θ was set to satisfy any of the following requirements (10-6) to (10-10), the prism sheet and the area light apparatus had a performance superior to a prism sheet and an area light apparatus that were designed without taking the reflection properties into consideration. That is, the front brightness ratio was higher than the prism sheet and the area light apparatus designed without taking the reflection properties into consideration.
(10-6) An angle in a range greater than 20.5° and less than 55°.

(10-7) An angle in a range no less than 25° and no more than 50°.
(10-8) An angle in a range greater than 20.5° and less than 55°.
(10-9) An angle in a range no less than 25° and no more than 50°.
(10-10) An angle in a range ±5° with respect to 45°.

(Evaluation 11)

When the range of the angle θ was set to satisfy the following requirement (11-1), the front brightness was higher than or equal to 1.30, which is the front brightness ratio of the area light apparatus of Evaluation (2), which used a commercially available prism sheet.

(11-1) An angle in a range greater than 35° and less than 50°.
When the range of the angle θ was set to satisfy any of the following requirements (11-2) to (11-5), the front brightness was higher than or equal to the front brightness ratio of the area light apparatus that used a commercially available prism sheet.
(11-2) An angle in a range greater than 35° and no more than 47.5°.
(11-3) An angle in a range no less than 40° and less than 50°.
(11-4) An angle in a range no less than 40° and no more than 47.5°.
(11-5) An angle in a range ±2.5° with respect to 45°.
Further, when the range of the angle θ was set to satisfy any of the following requirements (11-6) to (11-10), the front brightness was higher than or equal to the front brightness ratio of the area light apparatus that used a commercially available prism sheet.
(11-6) An angle in a range greater than 35° and less than 47.5°.
(11-7) An angle in a range greater than 35° and no more than 47°.
(11-3) An angle in a range no less than 40° and less than 47.5°.
(11-9) An angle in a range no less than 40° and no more than 47°.
(11-5) An angle in a range ±2° with respect to 45°.

(Evaluation 12)

When the range of the angle θ was set to satisfy the following requirement (12-1), the front brightness was higher than or equal to 1.50, which is the front brightness ratio of the area light apparatus of Evaluation (3), which used two commercially available prism sheets.

(12-1) An angle in a range greater than 43.5° and less than 46°.
Also, when the range of the angle θ was set to satisfy any of the following requirements (12-2) to (12-5), the front brightness ratio was greater than that of the area light apparatus of Evaluation (3).
(12-2) An angle in a range greater than 43.5° and no more than 45.5°.
(12-3) An angle in a range no less than 44° and less than 46°.
(12-4) An angle in a range no less than 44° and no more than 45.5°.
(12-5) An angle in a range ±0.5° with respect to 45°.

(Evaluation 13)

As obvious from Table 4, the prism sheet and the area light apparatus had a significantly superior performance when the angle θ was 45° compared to the cases where the angle θ had other values. That is, the front brightness ratio of the prism sheet and the area light apparatus was 1.62 when the angle θ was 45°.
Also, when the angle θ satisfied the following requirement (13-1) or preferably the requirement (13-2), the front brightness of the prism sheet 1 and the area light apparatus was no less than 90% of the case where the angle θ was 45°. That is, the prism sheet 1 and the area light apparatus had substantially the same performance as the case where the angle θ was 45°.

(13-1) An angle in a range ±2° with respect to 45°.
(13-2) An angle in a range ±1.5° with respect to 45°.
When the angle θ satisfied the following requirement (13-3) or preferably the requirement (13-4), the front brightness of the prism sheet 1 and the area light apparatus was no less than 80% of the case where the angle θ was 45°. That is, the prism sheet 1 and the area light apparatus had the same performance as the case where the angle θ was 45°.

(13-3) An angle in a range ±10° with respect to 45°.
(13-4) An angle in a range ±2.5° with respect to 45°.

<Example 4>

In Example 4, the area light apparatus was designed to be the same as that of Example 1, except that the index of refraction of the first prism sheet 1 was set to 1.64, and optical simulations were performed under the above conditions. The results are shown in Table 5.

Table 5:

| Angle θ, Front Brightness Ratio, and Magnitude of Front Brightness Ratio (Proportion) in each Angle θ with respect to Front Brightness Ratio when Angle θ is 45°, in Prism Sheet having Index of Refraction of 1.64 (n = 1.64) | | |
|---|---|---|
| Angle θ (deg) | Front Brightness Ratio | Proportion (%) |
| 15.0 | 0.43 | 25 |
| 20.0 | 0.99 | 58 |
| 25.0 | 1.27 | 74 |
| 30.0 | 1.25 | 73 |
| 32.5 | 1.26 | 73 |
| 34.0 | 1.35 | 78 |
| 40.0 | 1.43 | 83 |
| 42.5 | 1.52 | 88 |
| 43.0 | 1.57 | 91 |
| 43.5 | 1.58 | 92 |
| 44.0 | 1.59 | 92 |
| 44.5 | 1.68 | 98 |
| 45.0 | 1.72 | 100 |
| 45.5 | 1.70 | 99 |
| 46.0 | 1.68 | 98 |
| 46.5 | 1.64 | 95 |
| 47.0 | 1.60 | 93 |
| 47.5 | 1.57 | 91 |
| 50.0 | 1.25 | 73 |
| 52.5 | 1.45 | 84 |
| 55.0 | 1.22 | 71 |
| 57.5 | 1.11 | 65 |
| 60.0 | 1.02 | 59 |

(Evaluation)

As obvious from Table 5, even when the prism sheet had an index of refraction of 1.64, the front brightness was higher in some angles than the case when the angle θ was set to 34° without considering the reflection property. That is, the inventors of the present invention found out configurations for prism sheets and area light apparatuses having superior optical properties that cannot be achieved by conventional optical designs in which the reflection property is not taken into consideration. The evaluations will now be described in more details.

(Evaluation 14)

When the range of the angle θ was set to satisfy the following requirement (14-1), the front brightness ratio was higher than that of a prism sheet and an area light apparatus that were designed to have the angle θ of 34° without taking into reflection property into consideration.

(14-1) An angle in a range greater than 34° and less than 50°.
Also, when the range of the angle θ was set to satisfy any of the following requirements (14-2) to (14-5), the front brightness ratio was higher than or equal to that of a prism sheet and an area light apparatus that were designed without taking the reflection properties into consideration.
(14-2) An angle in a range no less than 40° and less than 50°.
(14-3) An angle in a range greater than 34° and no more than 47.5°.
(14-4) An angle in a range no less than 40° and no more than 47.5°.
(14-5) An angle in a range ±2.5° with respect to 45°.

(Evaluation 15)

When the range of the angle θ was set to satisfy the following requirement (15-1), the front brightness was higher than or equal to 1.30, which is the front brightness ratio of the area light apparatus of Evaluation (2), which used a commercially available prism sheet.

(15-1) An angle in a range greater than 34° and less than 50°.
Also, when the range of the angle θ was set to satisfy any of the following requirements (15-2) to (15-5), the front brightness ratio was higher than or equal to the front brightness ratio of the area light apparatus having a commercially available prism sheet.
(15-2) An angle in a range greater than 34° and no more than 47.5°.
(15-3) An angle in a range no less than 40° and less than 50°.
(15-4) An angle in a range no less than 40° and no more than 47.5°.
(15-5) An angle in a range ±2.5° with respect to 45°.

(Evaluation 16)

When the range of the angle θ was set to satisfy the following requirement (16-1), the front brightness was higher than or equal to 1.50, which is the front brightness ratio of the area light apparatus of Evaluation (3) having two commercially available prism sheets.

(16-1) An angle in a range greater than 34° and less than 50°.
Also, when the range of the angle θ was set to satisfy any of the following requirements (16-2) to (16-5), the front brightness ratio was greater than that of the area light apparatus of Evaluation (3).
(16-2) An angle in a range greater than 34° and no more than 47.5°.
(16-3) An angle in a range no less than 40° and less than 50°.
(16-4) An angle in a range no less than 40° and no more than 47.5°.
(16-5) An angle in a range ±2.5° with respect to 45°.

(Evaluation 17)

As obvious from Table 5, the prism sheet and the area light apparatus had a significantly superior performance when the angle θ is 45° compared to the cases where the angle θ had other values. That is, the front brightness ratio of the prism sheet and the area light apparatus was 1.72 when the angle θ was 45°.
Also, when the angle θ satisfies the following requirement (17-1) or preferably the requirement (17-2), the front brightness of the prism sheet 1 and the area light apparatus was no less than 90% of the case where the angle θ was 45°. That is, the prism sheet 1 and the area light apparatus had substantially the same performance as the case where the angle θ was 45°.

(17-1) An angle in a range ±2.5° with respect to 45°.
(17-2) An angle in a range ±2° with respect to 45°.
When the angle θ satisfied the following requirement (17-3) or preferably the requirement (17-4), the front brightness of the prism sheet 1 and the area light apparatus was no less than 80% of the case where the angle θ was 45°. That is, the prism sheet 1 and the area light apparatus had the same performance as the case where the angle θ was 45°.

(17-3) An angle in a range ±5° with respect to 45°.

(17-4) An angle in a range ±2.5° with respect to 45°.

Further, when the angle θ was approximately 52.5°, the prism sheet 1 and the area light apparatus had a performance in which the front brightness ratio was no less than 80% of that of the case where the angle θ was 45°. Also, when the angle θ was more than 47.5° and less than 57.5°, the prism sheet 1 and the area light apparatus had a performance in which the front brightness ratio was no less than 70% of that of the case where the angle θ was 45°.

<Example 5>

In Example 5, the area light apparatus was designed to be the same as that of Example 1, except that the index of refraction of the first prism sheet 1 was set to 1.7, and optical simulations were performed under the above conditions. The results are shown in Table 6.

Table 6:

| Angle θ, Front Brightness Ratio, and Magnitude of Front Brightness Ratio (Proportion) in each Angle θ with respect to Front Brightness Ratio when Angle θ is 45°, in Prism Sheet having Index of Refraction of 1.70 (n = 1.70) | | |
|---|---|---|
| Angle θ (deg) | Front Brightness Ratio | Proportion (%) |
| 15.0 | 0.44 | 26 |
| 20.0 | 0.55 | 33 |
| 25.0 | 1.22 | 73 |
| 30.0 | 1.16 | 69 |
| 32.5 | 1.24 | 74 |
| 37.5 | 1.30 | 77 |
| 40.0 | 1.41 | 84 |
| 42.5 | 1.51 | 90 |
| 43.0 | 1.56 | 93 |
| 43.5 | 1.59 | 95 |
| 44.0 | 1.62 | 96 |
| 44.5 | 1.66 | 99 |
| 45.0 | 1.68 | 100 |
| 45.5 | 1.67 | 99 |
| 46.0 | 1.65 | 98 |
| 46.5 | 1.64 | 98 |
| 47.0 | 1.55 | 92 |
| 47.5 | 1.52 | 90 |
| 50.0 | 1.34 | 80 |
| 52.5 | 1.49 | 89 |
| 55.0 | 1.35 | 80 |
| 57.5 | 1.15 | 68 |
| 60.0 | 1.04 | 62 |

(Evaluation)

As obvious from Table 6, even when the prism sheet had an index of refraction of 1.7, the front brightness was higher in some angles than the case when the angle θ was set to 37.5°. That is, the inventors of the present invention found out configurations for prism sheets and area light apparatuses having superior optical properties that cannot be achieved by conventional prism sheets that are designed without taking the reflection property into consideration. The evaluations will now be described in more details.

(Evaluation 18)

When the range of the angle θ was set to satisfy the following requirement (18-1), the front brightness ratio was higher than that of a prism sheet and an area light apparatus that were designed to have the angle θ of 34° without taking the reflection property into consideration.

(18-1) An angle in a range greater than 37.5° and less than 57.5°.
Also, when the range of the angle θ was set to satisfy any of the following requirements (18-2) to (18-5), the front brightness ratio was higher than or equal to that of a prism sheet and an area light apparatus that were designed without taking the reflection properties into consideration.
(18-2) An angle in a range no less than 40° and less than 57.5°.
(18-3) An angle in a range greater than 37.5° and no more than 55°.
(18-4) An angle in a range no less than 40° and no more than 55°.
(18-5) An angle in a range ±5° with respect to 45°.

(Evaluation 19)

When the range of the angle θ was set to satisfy the following requirement (19-1), the front brightness was higher than or equal to 1.30, which is the front brightness ratio of the area light apparatus of Evaluation (2) having a commercially available prism sheet.

(19-1) An angle in a range greater than 37.5° and less than 57.5°.
Also, when the range of the angle θ was set to satisfy any of the following requirements (19-2) to (19-5), the front brightness was higher than or equal to the front brightness ratio of the area light apparatus having a commercially available prism sheet.
(19-2) An angle in a range greater than 37.5° and no more than 55°.
(19-3) An angle in a range no less than 40° and less than 57.5°.
(19-4) An angle in a range no less than 40° and no more than 55°.
(19-5) An angle in a range ±5° with respect to 45°.

(Evaluation 20)

When the range of the angle θ was set to satisfy the following requirement (20-1), the front brightness was higher than or equal to 1.50, which is the front brightness ratio of the area light apparatus of Evaluation (3) having two commercially available prism sheets.

(20-1) An angle in a range greater than 40° and less than 50°.
Also, when the range of the angle θ was set to satisfy any of the following requirements (20-2) to (20-5), the front brightness ratio was greater than that of the area light apparatus of Evaluation (3).
(20-2) An angle in a range greater than 40° and no more than 47.5°.
(20-3) An angle in a range no less than 42.5° and less than 50°.
(20-4) An angle in a range no less than 42.5° and no more than 47.5°.
(20-5) An angle in a range ±2.5° with respect to 45°.

(Evaluation 21)

As obvious from Table 6, the prism sheet and the area light apparatus had a significantly superior performance when the angle θ was 45° compared to the cases where the angle θ had other values. That is, the front brightness ratio of the prism sheet and the area light apparatus was 1.68 when the angle θ was 45°.
Also, when the angle θ satisfied the following requirement (21-1), the front brightness of the prism sheet 1 and the area light apparatus was no less than 90% of the case where the angle θ was 45°. That is, the prism sheet 1 and the area light apparatus had substantially the same performance as the case where the angle θ was 45°.

(21-1) An angle in a range ±2.5° with respect to 45°.

When the angle θ satisfied the following requirement (21-2) or preferably the requirement (21-3), the front brightness of the prism sheet 1 and the area light apparatus was no less than 80% of the case where the angle θ was 45°. That is, the prism sheet 1 and the area light apparatus had the same performance as the case where the angle θ was 45°.

(21-2) An angle in a range ±10° with respect to 45°.

(21-3) An angle in a range ±5° with respect to 45°.

From Tables 1 to 6, even if the index of refraction of the first prism sheet is set any values other than the values listed above, the results are similar to those listed above.

The following points are true about the first prism sheet and the first area light apparatus.

<General Evaluation>

(i) It was found out that when a prism sheet was designed such that the range of the angle θ defined by the slope 13b of each projection 13 and the normal 11H to the incident surface 11 satisfies any of the following requirements (i-1) to (i-5), the prism sheet has superior optical properties (the property of changing path of rays and the property for gathering light) to a prism sheet the angle θ of which is designed without taking the reflection property into consideration.

(i-1) An angle in a range greater than 17° and less than 60°.
(i-2) An angle in a range greater than 20.5° and less than 60°.
(i-3) An angle in a range greater than 30° and less than 55°.
(i-4) An angle in a range greater than 34° and less than 50°.
(i-5) An angle in a range greater than 37.5° and less than 57.5°.

Also, it was found out that when the range of the angle θ is set to satisfy the following requirement (i-6), preferably the requirement (i-7), more preferably the requirement (i-8), further preferably the requirement (i-9), and particularly preferably the requirement (i-10), the prism sheet and the area light apparatus have superior optical properties to a prism sheet that is designed without taking the reflection property into consideration.

(i-6) An angle in a range ±15° with respect to 45°.
(i-7) An angle in a range ±10° with respect to 45°.
(i-8) An angle in a range ±7° with respect to 45°.
(i-9) An angle in a range ±5° with respect to 45°.
(i-10) An angle in a range ±2.5° with respect to 45°.

(ii) If an area light apparatus has a prism sheet in which the range of the angle θ is set to satisfy any of the following requirements (ii-1) to (ii-5), the area light apparatus has a greater front brightness than an area light apparatus that has one conventional prism sheet as shown in Fig. 4. That is, if the angle θ is set in any of the above listed ranges, the prism sheet has a significantly improved optical properties. Specifically, the prism sheet has a front brightness ratio no less than 1.30 given the above described conditions.

(ii-1) An angle in a range greater than 32.5° and less than 47°.
(ii-2) An angle in a range greater than 35° and less than 55°.
(ii-3) An angle in a range greater than 34° and less than 47.5°.
(ii-4) An angle in a range greater than 35° and less than 47°.
(ii-5) An angle in a range greater than 37.5° and less than 57.5°.

That is, the inventors found that if the angle θ is set in the range (ii-6), which is greater than 32.5° and less than 57.5°, the front brightness ratio is no less than 1.30.

Also, it was found out that when the range of the angle θ is set to satisfy the following requirement (ii-7), preferably the requirement (ii-8), more preferably the requirement (ii-9), further preferably the requirement (ii-10), the front brightness ratio is no less than 1.30.

(ii-7) An angle in a range ±5° with respect to 45°.
(ii-8) An angle in a range ±2.5° with respect to 45°.
(ii-9) An angle in a range ±2° with respect to 45°.
(ii-10) An angle in a range ±1.5° with respect to 45°.

(iii) If an area light apparatus has a prism sheet in which the range of the angle θ is set to satisfy any of the following requirements (iii-1) to (iii-4), the area light apparatus has a greater front brightness than an area light apparatus that has two conventional prism sheets as shown in Fig. 5 arranged such that the prisms lie perpendicular to each other. That is, if the angle θ is set in any of the above listed ranges, the prism sheet has a significantly improved optical properties. Specifically, the prism sheet has a front brightness ratio no less than 1.50 given the above described conditions.

(iii-1) An angle in a range greater than 34° and less than 50°.
(iii-2) An angle in a range greater than 40° and less than 50°.
(iii-3) An angle in a range greater than 40° and less than 47.5°.
(iii-4) An angle in a range greater than 43.5° and less than 46°.
 Also, when the range of the angle θ is set to satisfy the following requirement (iii-5), preferably the requirement (iii-6), and particularly preferably the requirement (ii-7), an improved prism sheet and an improved area light apparatus that have a front brightness ratio of 1.50 are obtained.
(iii-5) An angle in a range ±2.5° with respect to 45°.
(iii-6) An angle in a range ±1.5° with respect to 45°.
(iii-7) An angle in a range ±0.5° with respect to 45°.

(iv) A prism sheet the angle θ of which is in a range greater than 35° and no more than 60° has superior light gathering property to a prism sheet having cone shaped projections the angle θ of which is the same range, or in the range greater than 35° and no more than 60°, relative to the normal 11H to the incident surface. The reason for this is considered that pyramid shaped projections can be more densely provided on a side opposite from the incident surface, that is, on the light exit surface 12, than cone shaped projections.

(v) A prism sheet the angle θ of which is in a range greater than 35° and no more than 55° has superior light gathering property to a prism sheet having cone shaped projections the angle θ of which is in the same range, or in the range greater than 35° and no more than 55°, relative to the normal 11H to the incident surface. In this case, the prism sheet and an area light apparatus using the prism sheet have superior optical properties such as a front brightness ratio of 1.20.

(vi) A prism sheet the angle θ of which was greater than 40° and less than 50° had superior optical properties than a prism sheet having cone shaped projections and the same index of refraction.

(vii) When the angle θ was set to 45°, the prism sheet and the area light apparatus of this embodiment had the highest front brightness ratio compared to a prism sheet and an area light apparatus having the same index of refraction and a different angle θ. Also, it was found out that when the range of the angle θ is set to satisfy the following requirement (vii-1), preferably the requirement (vii-2), more preferably the requirement (vii-3), further preferably the requirement (vii-4), and particularly preferably the requirement (vii-5) with respect to 45°, the optical properties are substantially the same as the case where the angle θ is 45°.

(vii-1) An angle in a range ±10° with respect to 45°.
(vii-2) An angle in a range ±5° with respect to 45°.
(vii-3) An angle in a range ±2.5° with respect to 45°.
(vii-4) An angle in a range ±2° with respect to 45°.
(vii-5) An angle in a range ±1.5° with respect to 45°.

<Mechanisms>

The reason why the area light apparatus of this embodiment has an improved front brightness is the existence of optical paths (light) described in Mechanisms 1 to 4 below. The existence of the optical paths was discovered by the inventors of the present invention through repetitive performance of the simulations under the above listed conditions.

<Mechanism 1>

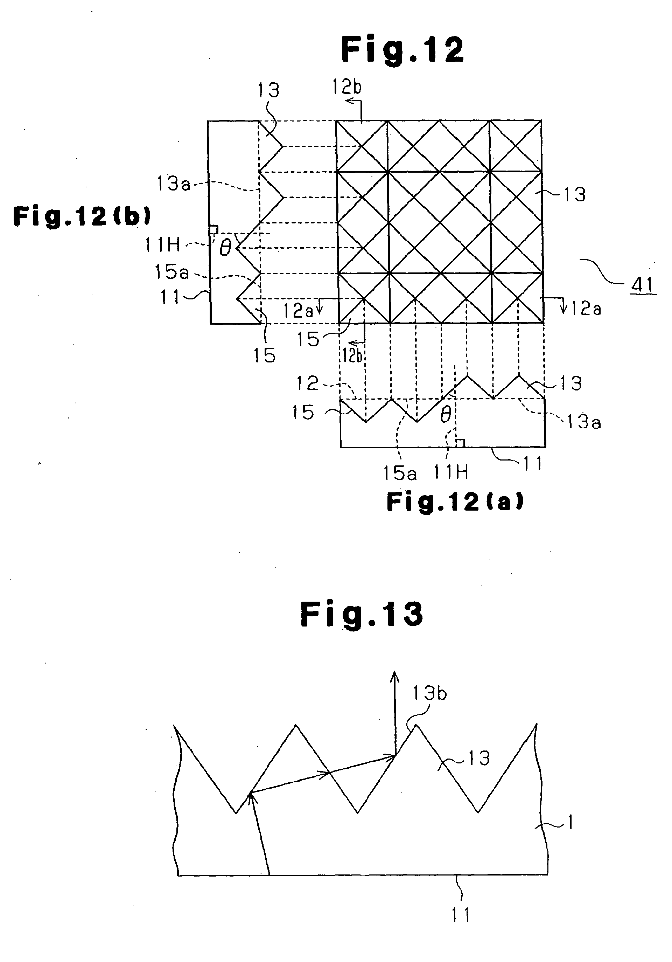

When the projections 13 of the prism sheet 1 are configured that the range of the angle θ is no less than 25° and no more than 45°, some of light that is emitted through one of the projections 13 is subjected to the Fresnel reflection at a slope 13b of an adjacent one of the projections 13 and advances in the front direction as shown in Fig. 13.

Therefore, even if the angle θ is greater than a case in which the prism sheet 1 is designed without taking the reflection property into consideration, the front brightness is increased.

<Mechanism 2>

When the angle θ of the projections 13 has a value close to 45°, the prism sheet 1 emits light of the following properties in the front direction.

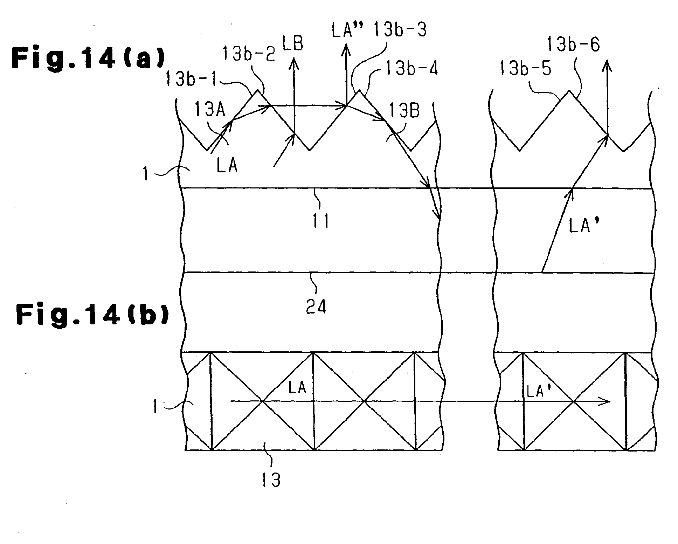

Ray LA in a direction that, when projected onto the incident surface 11, coincides with a line containing the peaks of adjacent projections as shown in Fig. 14(b).

In the cross-sectional view of Fig. 14(a), the ray LA is an incident light that reaches a slope 13b-1.

In the cross-sectional view of Fig. 14(a), the ray LA has the same angle of incidence as a ray LB that reaches the slope 13b-2, which is opposite from the slope 13b-1, and refracted to the front direction.

The ray LA is totally reflected by the slope 13b-1 and emitted to the outside through the slope 13b-2. The ray LA then reaches an adjacent projection 13 and is totally reflected by a slope 13b-4 at a side opposite from a slope 13b-3 through which the ray LA enters the projection 13.

The advancing direction of the ray LA between the projections 13A and 13B in the cross-sectional view of Fig. 14(a) of the above conditions was computed. The results showed that the advancing direction of the ray LA is substantially parallel to the incident surface 11. Since the entire prism sheet 1, including the projections 13A, 13B, has a uniform index of refraction, the angle of incidence of the ray LA at the slope 13b-1 and the angle of incidence of the ray LA at the slope 13b-4 are substantially the same. Therefore, a ray LA' reflected by the reflecting electrode 24 is substantially parallel to the ray LA in the cross-sectional view of Fig. 14(a). When reaching the slope 13b-6, which is at the same side as the slope 13b-2 and 13b-4, the ray LA' is emitted in the front direction.

After being emitted through the projection 13A, the ray LA is subjected to the Fresnel reflection at the slope 13b-3 of the projection 13B. Calculations reveals that the ray LA" after the Fresnel reflection also advances in the front direction.

It is considered that, due the existence of these optical paths, the prism sheet and the area light apparatus of this embodiment have the highest front brightness when the angle θ is in the vicinity of 45°.

<Mechanism 3>

When the angle θ of the projections 13 has a value close to 45°, the prism sheet 1 emits light of the following properties in the front direction.

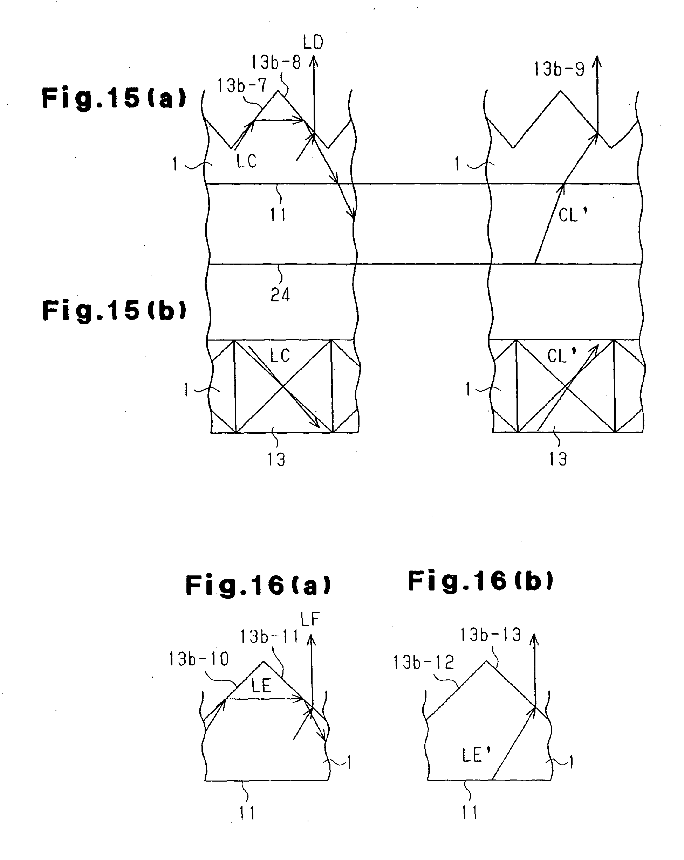

In the cross-sectional view of Fig. 15(a), a ray LC is an incident light that reaches a slope 13b-7.

In the cross-sectional view of Fig. 15(a), the ray LC has the same angle of incidence as a ray LD that reaches a slope that is opposite from the slope 13b-7 or an adjacent slope 13b (hereinafter denoted as 13b-8), and refracted to the front direction.

In the front view of Fig. 15(b), the direction of the ray LC does not coincide with a line that contains peaks of adjacent projections 13.

The results of the simulations revealed that, when the ray LC is totally reflected by the slope 13b-7 in the cross-sectional view of Fig. 15(a), some components of the ray LC advances in a direction parallel to the incident surface 11. When reaching the slope 13b-7 of the projection 13 or the opposing slope 13b-8, such components of light are reflected toward the reflecting electrode 24. At this time, the angle defined by the slope 13b-8 and the direction of the light is substantially the same as the angle defined by the ray LC and the slope 13b-7. Therefore, when the light is reflected by the reflecting electrode 24 and a slope 13b-9 at the same side as the slope 13b-8, the light is emitted in the front direction (LC' in the drawing).

The effect of this mechanism cannot be achieved by, for example, the conventional prism sheet of Fig. 4, which has no pyramid-shaped projections such as projections 13. It is thus considered that the area light apparatus of this embodiment has a higher front brightness than area light apparatus having a conventional prism sheet.

<Mechanism 4>

The prism sheet the index of refraction of which is 1.64 has an increased front brightness ratio when the angle θ is approximately 52.5°, and the prism sheet the index of refraction of which is 1.40 has an increased front brightness ratio when the angle θ is approximately 51°. The reason for this is considered that these prism sheet satisfy the following requirements.

Ray LE in a direction that, when projected onto the incident surface 11, coincides with a line containing the peaks of adjacent projections.

In the cross-sectional view of Fig. 16(a), the ray LE is an incident light that reaches a slope 13b-10.

In the cross-sectional view of Fig. 16(a), the ray LE advances in a direction parallel to a ray LF that reaches the slope 13b-11, which is opposite from the slope 13b-10, and emitted in the front direction.

As shown in Fig. 16(a), the ray LE is totally reflected by the slope 13b-10 and is reflected by the slope 13b-11 toward the reflecting electrode 24.

The advancing direction of the ray LE between the slope 13b-10 and 13b-11 in the cross-sectional view of Figs. 16(a) and 16(b) after reflected by the slope 13b-10 was computed. The results showed that the advancing direction of the ray LD is substantially parallel to the incident surface 11. Therefore, the angle of incidence of the ray LE at the slope 13b-10 is substantially the same as the output angle at the slope 13b-11. Therefore, as shown in Fig. 16(b), the ray LE' reflected by the reflecting electrode 24 is substantially parallel to the ray LE. When reaching the slope 13b-13, which is at the same side as the slope 13b-11, the ray LE' is emitted in the front direction.

In this manner, the prism sheet 1 and the area light apparatus of this embodiment have a greater number of optical paths to direct light in the front direction than conventional prism sheets and area light apparatuses. This is considered to have increased the front brightness of the prism sheet 1 and the area light apparatus of this embodiment.

In other words, the prism sheet of this embodiment has a greater number of luminous fluxes advancing along the optical paths described below than conventional prism sheets, and therefore has the above described significantly improved optical properties.

Specifically, the ray LD in Fig. 15(a) and the ray LF in Fig. 16(a) are emitted in the front direction after reaching one of the slopes 13b (provisionally denoted as 13b-A). The ray LC in Fig. 15(a) advances in a direction parallel to the direction of the rays LD, LF in the prism sheet 1 and reaches one of the slopes 13b (provisionally denoted as 13b-B) that is different from the slope 13b-A. The ray LC is reflected by the slope 13b-B and advances in a direction parallel to the incident surface 11. The ray LC is then reflected toward the reflecting electrode 24 by another one of the slopes 13b (provisionally denoted as 13b-C) that is different from the slope 13b-B. The ray LC is then reflected toward the prism sheet 1 by the reflecting electrode 24. The reflected ray LC, or a ray LC', then reaches another slope 13b (provisionally denoted as 13b-D) and is emitted in a path along the front direction from the slope 13b-D.

Also, the first area light apparatus 101 and the first prism sheet 1 exerted favorable properties even if the reflecting electrode 24 was inclined relative to the light extracting surface 25 (the incident surface 11). Examples will now be described.

<Example 6>

In the following, an area light apparatus that was the same as the area light apparatus in Example 1 except for the following differences was subjected to simulations as in Example 1. The results are shown in Table 7.

In the area light apparatus of the example 1, an end (a side) of the reflecting electrode 24 was fixed and the other end was moved. The amount of movement is represented by an angle with respect to the position of the reflecting electrode 24 in Example 1, which position is referred to as an inclination angle of 0°.

The angle θ was set to 35°.

Table 7:

| Inclination (Inclination Angle) of Reflector Plate, Front Brightness Ratio, and Magnitude of Front Brightness Ratio (Proportion) with respect to Front Brightness Ratio when Inclination Angle is 0° in the case where Index of Refraction is 1.5 (n = 1.5) and angle θ is 35° | | |
|---|---|---|
| Inclination Angle θ (deg) | Front Brightness Ratio | Proportion (%) |
| 0 | 1.26 | 100 |
| 1 | 1.25 | 99 |
| 2 | 1.27 | 101 |
| 3 | 1.27 | 101 |
| 4 | 1.31 | 104 |
| 5 | 1.31 | 104 |
| 6 | 1.28 | 102 |
| 7 | 1.28 | 102 |
| 8 | 1.29 | 102 |
| 9 | 1.28 | 102 |

Table 7:   (continued)

| Inclination (Inclination Angle) of Reflector Plate, Front Brightness Ratio, and Magnitude of Front Brightness Ratio (Proportion) with respect to Front Brightness Ratio when Inclination Angle is 0° in the case where Index of Refraction is 1.5 (n = 1.5) and angle θ is 35° | | |
|---|---|---|
| Inclination Angle θ (deg) | Front Brightness Ratio | Proportion (%) |
| 10 | 1.27 | 101 |
| 15 | 1.12 | 89 |
| 20 | 1.07 | 85 |
| 25 | 1.04 | 83 |

<Example 7>

In Example 7, the area light apparatus was designed to be the same as that of Example 6, except that the angle θ was set 40°, and simulations were performed as in Example 1. The results are shown in Table 8.

Table 8:

| Inclination (Inclination Angle) of Reflector Plate, Front Brightness Ratio, and Magnitude of Front Brightness Ratio (Proportion) with respect to Front Brightness Ratio when Inclination Angle is 0° in the case where Index of Refraction is 1.5 (n = 1.5) and angle θ is 40° | | |
|---|---|---|
| Inclination Angle θ (deg) | Front Brightness Ratio | Proportion (%) |
| 0 | 1.41 | 100 |
| 1 | 1.39 | 99 |
| 2 | 1.40 | 99 |
| 3 | 1.41 | 100 |
| 4 | 1.43 | 102 |
| 5 | 1.42 | 101 |
| 6 | 1.40 | 99 |
| 7 | 1.43 | 101 |
| 8 | 1.40 | 100 |
| 9 | 1.39 | 99 |
| 10 | 1.39 | 99 |
| 15 | 1.21 | 86 |
| 20 | 1.19 | 84 |
| 25 | 1.16 | 83 |

<Example 8>

In Example 8, the area light apparatus was designed to be the same as that of Example 6, except that the angle θ was set 43°, and simulations were performed as in Example 1. The results are shown in Table 9.

Table 9:

| Inclination (Inclination Angle) of Reflector Plate, Front Brightness Ration, and Magnitude of Front Brightness Ratio (Proportion) with respect to Front Brightness Ratio when Inclination Angle is 0° in the case where Index of Refraction is 1.5 (n = 1.5) and angle θ is 43° | | |
|---|---|---|
| Inclination Angle θ (deg) | Front Brightness Ratio | Proportion (%) |
| 0 | 1.60 | 100 |

Table 9: (continued)

| Inclination (Inclination Angle) of Reflector Plate, Front Brightness Ration, and Magnitude of Front Brightness Ratio (Proportion) with respect to Front Brightness Ratio when Inclination Angle is 0° in the case where Index of Refraction is 1.5 (n = 1.5) and angle θ is 43° | | |
|---|---|---|
| Inclination Angle θ (deg) | Front Brightness Ratio | Proportion (%) |
| 1 | 1.61 | 101 |
| 2 | 1.59 | 99 |
| 3 | 1.59 | 99 |
| 4 | 1.57 | 98 |
| 5 | 1.52 | 95 |
| 6 | 1.52 | 95 |
| 7 | 1.50 | 94 |
| 8 | 1.47 | 92 |
| 9 | 1.44 | 90 |
| 10 | 1.41 | 88 |

<Example 9>

In Example 9, the area light apparatus was designed to be the same as that of Example 6, except that the angle θ was set 45°, and simulations were performed as in Example 1. The results are shown in Table 10.

Table 10:

| Inclination (Inclination Angle) of Reflector Plate, Front Brightness Ratio, and Magnitude of Front Brightness Ratio (Proportion) with respect to Front Brightness Ratio when Inclination Angle is 0° in the case where Index of Refraction is 1.5 (n = 1.5) and angle θ is 45° | | |
|---|---|---|
| Inclination Angle θ (deg) | Front Brightness Ratio | Proportion (%) |
| 0 | 1.69 | 100 |
| 1 | 1.67 | 99 |
| 2 | 1.66 | 98 |
| 3 | 1.61 | 95 |
| 4 | 1.54 | 91 |
| 5 | 1.49 | 88 |
| 6 | 1.47 | 87 |
| 7 | 1.45 | 86 |
| 8 | 1.42 | 84 |
| 9 | 1.40 | 83 |
| 10 | 1.37 | 81 |
| 15 | 1.31 | 77 |
| 20 | 1.18 | 70 |
| 25 | 1.14 | 67 |

<Example 10>

In Example 10, the area light apparatus was designed to be the same as that of Example 6, except that the angle θ was set 52.5°, and simulations were performed as in Example 1. The results are shown in Table 11.

Table 11:

| Inclination (Inclination Angle) of Reflector Plate, Front Brightness Ratio, and Magnitude of Front Brightness Ratio (Proportion) with respect to Front Brightness Ratio when Inclination Angle is 0° in the case where Index of Refraction is 1.5 (n = 1.5) and angle θ is 52.5° | | |
|---|---|---|
| Inclination Angle θ (deg) | Front Brightness Ratio | Proportion (%) |
| 0 | 1.21 | 100 |
| 1 | 1.22 | 101 |
| 2 | 1.22 | 101 |
| 3 | 1.20 | 99 |
| 4 | 1.22 | 101 |
| 5 | 1.20 | 99 |
| 6 | 1.23 | 102 |
| 7 | 1.22 | 101 |
| 8 | 1.22 | 101 |
| 9 | 1.21 | 100 |
| 10 | 1.18 | 97 |
| 15 | 1.15 | 95 |
| 20 | 1.12 | 93 |
| 25 | 1.08 | 90 |

(Evaluation)

As the inclination angle of the reflecting electrode 24 was increased, the amount of light that reaches the prism sheet 1 was decreased. However, as obvious from Examples 6 to 10, even when the reflecting electrode 24 was inclined, the same front brightness ratio as the case where the inclination angle was 0° was obtained.

As obvious from Example 6, when the angle θ was 35°, the same optical properties as the case in which the inclination angle was 0° were obtained if the inclination angle was in a range greater than 0° and less than 15°. Also, even when the inclination angle was in a range greater than 0° and no more than 25°, significantly improved optical properties were obtained. Specifically, the front brightness ratio was no less than 83% of a case where the inclination angle is 0°.

As obvious from Example 7, when the angle θ was 40°, the same optical properties as the case in which the inclination angle was 0° were obtained if the inclination angle was in a range greater than 0° and less than 15°. Also, even when the inclination angle was in a range greater than 0° and no more than 25°, significantly improved optical properties were obtained. Specifically, the front brightness ratio was no less than 83% of a case where the inclination angle is 0°.

As obvious from Example 8, when the inclination angle was in a range greater than 0° and no more than 20° and the angle θ was 43°, significantly improved optical properties were obtained. Specifically, the front brightness ratio was no less than 88% of a case where the inclination angle is 0°.

As obvious from Example 9, when the inclination angle was in a range greater than 0° and no more than 10° and the angle θ was 45°, significantly improved optical properties were obtained. Specifically, the front brightness ratio was no less than 81% of a case where the inclination angle is 0°. Also, even when the inclination angle was in a range greater than 0° and no more than 25°, improved optical properties were obtained. Specifically, the front brightness ratio was no less than 67% of a case where the inclination angle is 0°.

As obvious from Example 10, when the inclination angle is in a range greater than 0° and no more than 25°, and the angle θ was 52.5°, the same or better front brightness ratio as the case in which the inclination angle was 0° was obtained.

In this manner, when performing the above describe simulations, substantially the same optical properties as the case where the inclination angle is 0° are obtained if the inclination angle was in a range greater than 0° and no more than 25°, particularly when the inclination angle was greater than 0° and no more than 10°.

Accordingly, an area light apparatus in which a plurality of asperities are formed at least on the reflecting electrode 24 has a significantly improved optical properties. Forming asperities increases the amount of light emitted from the organic EL device 2 compared to an organic EL device having no asperities. Also, the prism sheet 1 increases the front brightness.

In the above described embodiment, the prism sheet 1 may be inclined relative to the reflecting electrode 24.

Even if modified as described below, the first area light apparatus and the first prism sheet have superior optical properties that cannot be achieved by conventional prism sheets that are designed without taking the reflection property into consideration.

Modifications of the embodiment will now be described. The modifications below may be combined as long as they do not conflict with each other.

<Modification 1: Projections of Pyramid other than Square Pyramid>

The projections 13 on the first prism sheet may be pyramids other than square pyramids. As described above, the reason why the first prism sheet has a significantly increased brightness in a specific direction is that the slopes 13b of the projections are in any of the above described ranges of the angle θ. Therefore, as long as the slopes 13b of the projections 13 are in any of the above described ranges of the angle θ, the shape of the projections 13 may be changed to pyramids other than square pyramids. For example, the same optical properties as described above can be obtained even if the projections 13 are formed as triangular pyramids, equilateral triangular pyramids, rectangular pyramids, hexagonal pyramids, or equilateral hexagonal pyramids.

At this time, the angle of at least one side of each pyramid needs to be in any of the above described ranges. Preferably, if the pyramids are designed such that the angles of all the sides of each pyramid are in any of the angle ranges, a prism sheet and an area light apparatus having a significantly improved optical properties are obtained.

When square pyramid shaped projections are used, a higher property for changing optical paths is obtained if the pyramids, or the projections, are densely arranged on a side opposite from an incident surface. Therefore, among all kinds of pyramids, equilateral triangular pyramids, square pyramids, rectangular pyramids, hexagonal pyramids, and equilateral hexagonal pyramids are preferable since each side of each pyramid can be arranged to be common to an adjacent pyramid.

If the projections 13 are formed by carving a transparent plate, the shape of the projections 13 are preferably square pyramids since the number of steps of carving is less than the case of other types of pyramids.

<Modification 2: Truncated Pyramids>

As obvious from the results of the above simulations, the first prism sheet 1 has an improved property for changing optical path because the angle the slopes 13b of each pyramid, which is the projection 13, is set to satisfy any of the above described requirements. Therefore, if the projections have slopes the angle of which is in any of the above described angle ranges, an improved prism sheet is obtained. That is, even if the projections are truncated pyramids or even if one or more of the slopes of each pyramid is curved, it is possible to improved optical properties to a level that cannot be achieved by a prism sheet that is designed without taking the reflection property into consideration. That is, it is possible to form a prism sheet and an area light apparatus that have superior optical properties and are different from conventional prism sheet and area light apparatus.

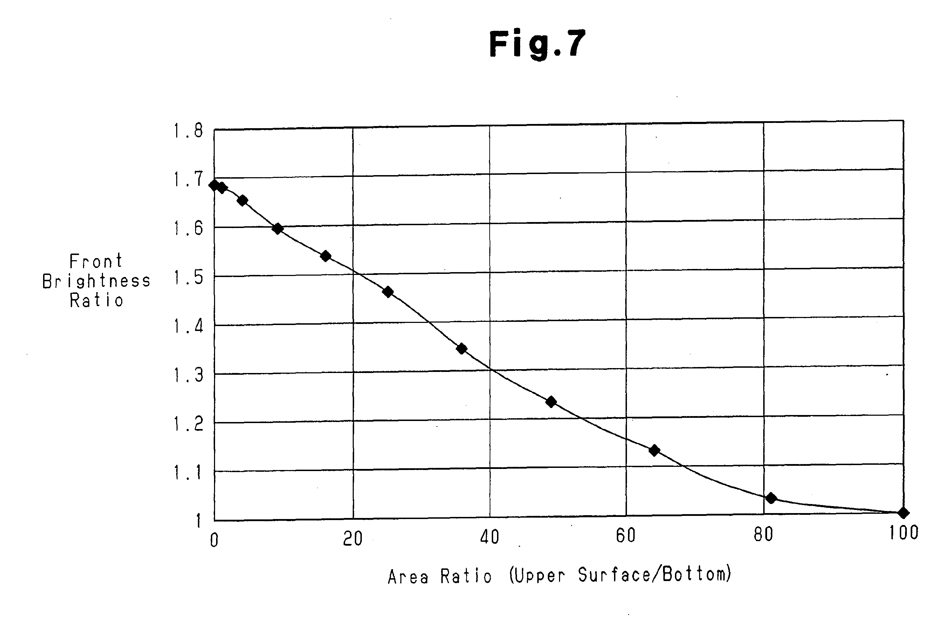

Simulations were performed with a prism sheet shown in Fig. 6 with the angle θ of the slopes 13b with respect to the normal 11H to the incident surface set to 45°. The conditions were the same as the simulations described above except that the prism sheet had square truncated pyramids instead of square pyramids. The results are shown in the graph of Fig. 7. The horizontal axis of the graph represents the area ratio of an upper surface 13c to a bottom 13a of each truncated pyramid. The vertical axis represents the front brightness ratio with respect to the front brightness of the organic EL device 2.

As obvious from Fig. 7, even if the projections were formed as truncated square pyramids, improved optical properties such as a property for changing optical paths and property for gathering light were obtained as in the above embodiment.

Also, the optical properties are improved even if the projections of Fig. 6 are replaced by other types of truncated pyramids as long as each of such pyramids has at least one slope in any of the above listed angle ranges.

Further, if all the slopes of each of such truncated pyramids are in any of the listed angle ranges, a prism sheet and an area light apparatus having superior optical properties as described above are obtained.

Thus, it was found out that, even if the configurations were made different from conventional configurations, optical properties equal to or higher than conventional optical properties are obtained.

<Modification 3: Cones>

As obvious from Table 2, it was found out that even if the projections of the prism sheet are shaped as cones as shown in Fig. 3, it is possible to obtain optical properties that cannot be achieved by conventional prism sheets that are designed without the reflection property into consideration and area light apparatus having such a prism sheet.

Specifically, when the angle defined by the normal 11H to the incident surface and a slope 14b of each projection (cone) 14 was set in the angle range (22-1) below, the front brightness was higher than that of a prism sheet that has cones the angle of which is 25°, and exerts the maximum front brightness when the reflection property is not taken into consideration. That is, when the projections 14 were formed into cones the slopes of which were in the angle range shown below with respect to the normal 11H to the incident surface, an improved optical properties were obtained. The slope of a cone refers to a surface of a cone other than the bottom and corresponds to slopes of a pyramid.

(22-1) An angle in a range greater than 42.5° and less than 55°.

When the angle defined by the slopes 14b of the projections and the normal 11H to the incident surface was set to satisfy any of the following requirements (22-2) to (22-4), the area light apparatus exerted optical properties superior to an area light apparatus shown having a prism sheet designed without taking the reflection property into consideration.

(22-2) An angle in a range greater than 42.5° and no more than 50°.
(22-3) An angle in a range no less than 44° and less than 55°.
(22-4) An angle in a range no less than 44° and no more than 50°.

When the angle defined by the normal 11H to the incident surface and the slope 14b of each projection (cone) was set to satisfy any of the requirements (23-1) to (23-4), the optical properties of the prism sheet was superior to those of the area light apparatus shown in Fig. 4, which has a front brightness ratio of 1.30. That is, the prism sheet had better optical properties than conventional prism sheets. Also, the brightness of the area light apparatus in a specific direction was higher than the brightness in other directions.

(23-1) An angle in a range greater than 40° and less than 55°.
(23-2) An angle in a range greater than 40° and no more than 50°.
(23-3) An angle in a range no less than 42.5° and less than 55°.
(23-4) An angle in a range no less than 42.5° and no more than 50°.

Further, even when the angle defined by the normal 11H to the incident surface and the slope 14b was set to satisfy any of the requirements (24-1) to (24-4), which requirements are never applied in the conventional design where the reflection property is not taken into consideration, the prism sheet and the area light apparatus had sufficient light gathering property and thus had a front brightness that is higher than the front brightness of organic EL devices.

(24-1) An angle in a range greater than 30° and less than 55°.
(24-2) An angle in a range greater than 30° and no more than 50°.
(24-3) An angle in a range no less than 35° and less than 55°.
(24-4) An angle in a range no less than 35° and no more than 50°.

Also, simulations were performed for a case where the index of refraction of the prism sheet was values other than 1.50. As a result, as in the previous simulations, the prism sheet of this embodiment, which had a greater value of the angle θ than a conventional prism sheet designed without taking the reflection property into consideration, had a superior optical property.

Further, the same simulations were performed for prism sheets the index of refraction of which were 1.40, 1.60, and 1.64. The results of these simulations and the results of the simulations shown in Table 1 of the prism sheet the index of refraction of which was 1.50 at least showed the following facts regarding prism sheets the indexes of refraction which are in a range between 1.40 and 1.64, inclusive, or in a generally used range.

(viii) When the angle θa defined by the normal 11H to the incident surface and the slope 14b of each projection 14 is in a range greater than 42.5° and less than 55°, the prism sheet has better optical properties (property for changing optical paths, property for gathering light) than a prism sheet the angle θa of which is set to the optimal value in a range no less than 17° and no more than 34°.

(ix) An area light apparatus having a prism sheet the angle θ of which is greater than 40° and less than 55° has a higher front brightness than an area light apparatus having one conventional prism sheet shown in Fig. 4. That is, if the angle θa is set in any of the above listed ranges, the prism sheet has a significantly improved optical property. Specifically, the prism sheet has a front brightness ratio no less than 1.30 given the above described conditions.

(x) If the angle θa of a prim sheet is set in a range no less than 35° and less than 55°, the prism sheet cannot be used in a conventional design in which the reflection property is not taken into consideration and the angle θa is set in a range between 17° and 34°, inclusive. Such a prism sheet has a sufficient light gathering property and thus has a front brightness that is higher than the front brightness of organic EL devices.

As in the case of pyramid shaped projections, even if the index of refraction is outside of the above listed ranges, a prism sheet has superior optical properties as long as the angle θa is in any of the above listed ranges. Accordingly, it was found out that optical properties that are equal to or better than those of conventional prism sheets and area light apparatus can be obtained, and that a prism sheet and an area light apparatus that are different from conventional ones are obtained.

<Modification 4: Truncated Cones>

As in Modification 2, if the projections are shaped like truncated cones, superior optical properties as shown above are obtained.

<Modification 5: Uneven Sizes of Projections not Covering Entire Surface>

As described above, favorable optical properties are obtained when the projections are shaped like pyramids, truncate pyramids, cones, or truncated cones as long as each projection has a slope the angle of which is any of the above listed ranges. Therefore, even if a prism sheet is designed such that at least one of the projections has a shape different from the shapes of the other projections, such that the bases of the projections do not contact one another, or such that a side of any projection is not common to any other projection, the prism sheet has the property for changing optical paths as described above.

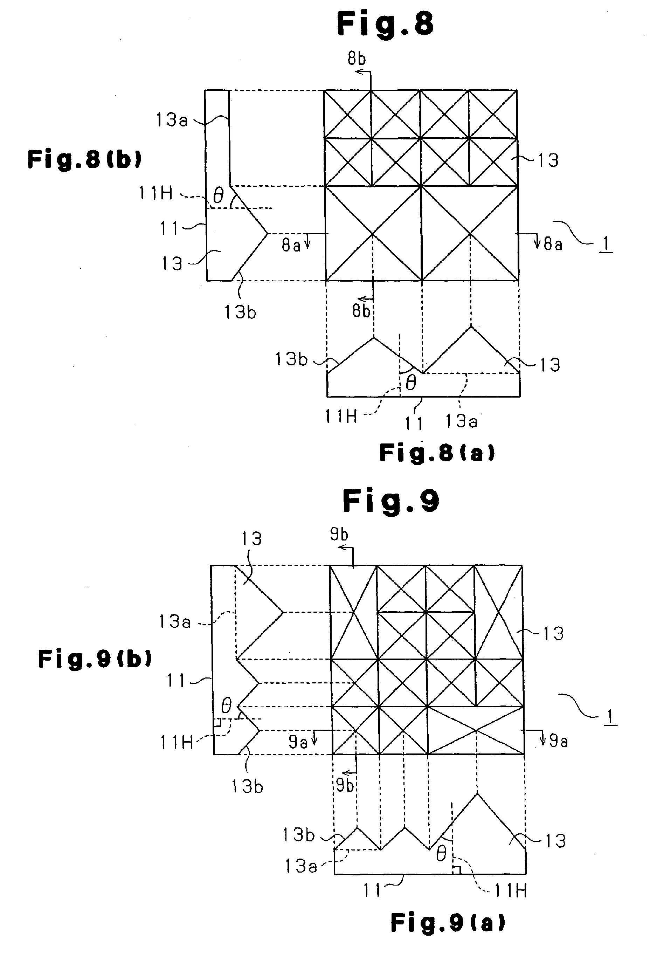

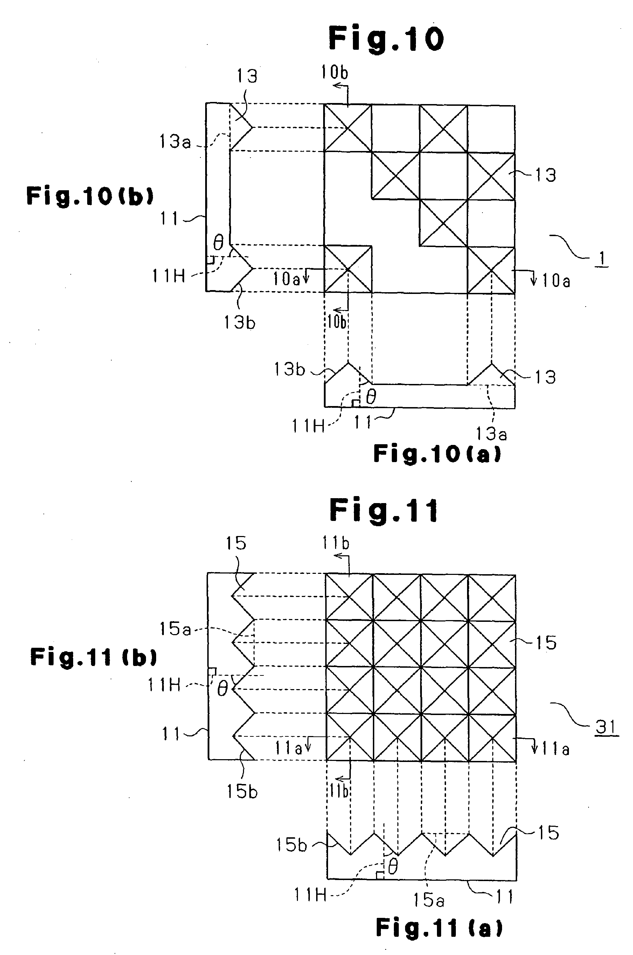

That is, as long as each projection 13 has at least one slope 13b and the angle of the slope 13b relative to the normal to a light exit surface is in any of the above listed ranges, the property for changing optical paths described above is obtained. For example, the projections on a prism sheet may be shaped as shown in any of Figs. 8, 9, and 10. In a modification of Fig. 8, the projections 13 are shaped as square pyramids of different sizes. In a modification of Fig. 9, the projections 13 include rectangular pyramids and square pyramids. In a modification of Fig. 10, the projections 13 are shaped as square pyramids the sides of which do not contact. It is preferable that all the slopes 13b of the projections 13 on the first prism sheet have an angle in any of the above listed angle ranges relative to the normal 11H to the incident surface 11 so that the prism sheet has significantly superior optical properties.

In this specification, the prism sheets in the above embodiment include prism sheets that have projections shaped like pyramids, truncated pyramids, cones, or truncated cones even if the projections only partly cover the surface of the prism sheet and have no slopes the angle of which is in any of the above listed angle ranges.

<Modification 6: Use of Other Types of Area Light-Emitting Device>

Area light-emitting devices other than organic EL devices may be employed as long as the devices has an isotropic light emission property and a reflection property. For example, inorganic electroluminescent devices or area light-emitting devices of an optical waveguide type may be used. Further, when organic EL devices are used, the type of the devices is not limited to the bottom emission type shown in Fig. 1, but may be a top emission type or a type that emits light from edges of a transparent substrate.

The wavelength of emitted light may be changed as necessary.

The prism sheets of the above embodiment do not need to be used in the area light-emitting devices having the above described light emitting properties, but may be used in area light-emitting devices having other light-emitting properties.

It was found out that if a prism sheet is designed such that any of the requirements of angle ranges is satisfied and used with an area light-emitting device that has the greatest number of luminous fluxes in a direction in an angle range no less than 30 and no more than 60 relative to the normal to the light extracting surface 25, significantly improved optical properties are obtained.

<Modification 7: Incorporate Area Light Apparatus as Backlight in Display>

If the first area light apparatus is incorporated in a display and used as a backlight, the display appears extremely clearly since the first area light apparatus has a significantly high front brightness.

As the display panel of the display, a conventional display panel such as a transmissive liquid crystal display panel, or a semitransparent liquid crystal display panel may be used.

<Modification 8: Bring First Prism Sheet and Organic EL Device into Close Contact>

In the above embodiment, a space exists between the first prism sheet 1 and the organic EL device 2. However, the first prism sheet 1 and the organic EL device 2 may be arranged to contact each other. If the first prism sheet 1 and the organic EL device 2 closely contact each other, part of or all of the light that would be totally reflected by the interface between the light extracting surface 25 of the organic EL device 2 and the exterior of the device 2 (generally, air) toward the interior of the device 2 is extracted to the outside of the device 2 through the first prism sheet 1.

<Modification 9: Arrange Other Types of Optical Members>

Conventional optical members other than the first prism sheet and the organic EL device may be employed as necessary. For example, a diffusion plate may be added to the first area light apparatus.

<Modification 10: Use Two or More Prism Sheets>

Two or more of the first prism sheets may be used. In this case, the first prism sheets are stacked.

The above described modifications may be combined as long as they do not conflict with each other.

An area light apparatus according to a second embodiment (a second area light apparatus) will now be described with reference to Fig. 11. The second area light apparatus is the same as the first area light apparatus 101 shown in Fig. 1 except that a second prism sheet 31 used in the second area light apparatus is different from the first prism sheet 1 shown in Fig. 1. Therefore, detailed description regarding the components that are the same as those in the first area light apparatus is omitted.

The second prism sheet 31 has square pyramid shaped recesses 15. Each recess 15 is deepened toward the incident surface 11. As shown in Figs. 11(a) and 11(b), the recesses 15 are defined by slopes 15b. The angle defined by each slope 15b and the normal 11H to the incident surface 11 is set to satisfy any of the above listed requirements. An bottom 15a of each recess 15 is located in an imaginary plane that lies substantially parallel to the incident surface 11. The bottom 15a of each adjacent pair of the recesses 15 are formed continuously.

Since the second prism sheet 31 has the slopes 15b that are in any of the above listed angle ranges relative to the normal 11H of the incident surface 11, the second prism sheet 31 has the same optical properties as in the first embodiment.

Like the first area light apparatus 101 shown in Fig. 1, the second area light apparatus may be modified. The recesses 15 need not be shaped like square pyramids. For example, the recesses 15 may be shaped like truncated pyramids, cones, or truncated cones. The slopes 15b need not be strictly planar as long as the slopes 15b are in any of the above listed angle ranges. That is, as long as the slopes 15b can be substantially planar, each slope 15b may include a curved section or may be entirely a curved plane.

Fig. 12 illustrates a modification of the second prism sheet 31 shown in Fig. 11. A prism sheet 41 of this modification is a combination of the first prism sheet 1 shown in Fig. 1 and the second prism sheet 31 shown in Fig. 11. That is, the prism sheet 41 has a mixed structure having the projections 13 and the recesses 15. Since the slopes 13b of the projections 13 and the slopes 15b of the recesses 15 are in any of the above listed angle ranges relative to the normal to the incident surface 11, the same optical properties as described above are obtained.

The present examples and embodiments are to be considered as illustrative and not restrictive and the invention is not to be limited to the details given herein, but may be modified within the scope and equivalence of the appended claims.

An optical device has an incident surface and a light exit surface located at an opposite side from the incident surface. The light exit surface defines a plurality of projections. The projections project away from the incident surface. Sections of the light exit surface that define projections include side faces of pyramids. Each of the pyramids has a bottom that is an imaginary plane substantially parallel to the incident surface. The side faces of each pyramid are slopes. At least one of the slopes is inclined at a range greater than 17° and less than 60° relative to the normal to the incident surface.

**Claims**

**1.** An optical device for changing an optical path of light that reaches the device,

wherein the optical device is transparent, the optical device comprising an incident surface and a light exit surface located at an opposite side from the incident surface, wherein the light exit surface defines a plurality of projections and/or recesses, the projections projecting away from the incident surface, and the recesses being dented toward the incident surface, the optical device being **characterized in that**:

sections of the light exit surface that define projections and/or recesses include side faces of pyramids or truncated pyramids, each of the pyramids and the truncated pyramids having a bottom that is an imaginary plane substantially parallel to the incident surface, wherein the side faces of each of the pyramids and the truncated pyramids are slopes, at least one of the slopes being inclined at a predetermined angle relative to the normal to the incident surface, wherein the predetermined angle is in a range greater than 17° and less than 60°.

2. The optical device according to claim 1,
**characterized in that** all the slopes forming the side faces are inclined at the predetermined angle relative to the normal.

3. The optical device according to claim 1,
**characterized in that** the predetermined angle is in a range greater than 30° and less than 55°.

4. The optical device according to claim 1,
**characterized in that** n the predetermined angle is in a range greater than 40° and less than 50°.

5. The optical device according to claim 1,
**characterized in that** the predetermined angle is in a range greater than 40° and less than 47.5°.

6. The optical device according to claim 1,
**characterized in that** the pyramids are triangular pyramids, rectangular pyramids, or hexagonal pyramids.

7. The optical device according to claim 1,
**characterized in that** the pyramids are equilateral triangular pyramids, square pyramids, or equilateral hexagonal pyramids,
wherein the projections or the recesses are arranged such that each of the sides defining the bottom of each pyramid is common to one of the sides defining the bottom of an adjacent pyramid.

8. The optical device according to claim 1,
**characterized in that** the truncated pyramids are truncated triangular pyramids, truncated rectangular pyramids, or truncated hexagonal pyramids.

9. The optical device according to claim 1,
**characterized in that** the truncated pyramids are truncated equilateral triangular pyramids, truncated square pyramids, or truncated equilateral hexagonal pyramids, wherein the projections or the recesses are arranged such that each of the sides defining the bottom of each truncated pyramid is common to one of the sides defining the bottom of an adjacent truncated pyramid.

10. An area light apparatus **being characterized by** the optical device according to any one of claims 1 to 9, and an area light-emitting device having an isotropic light emission property, wherein the area light-emitting device includes a light extracting surface, wherein the optical device is provided at a side of the light extracting surface, and wherein the area light-emitting device includes has a reflection property to reflect light from the optical device toward the optical device.

11. The area light apparatus according to claim 10,
**characterized in that** the area light-emitting device is an organic electroluminescent device or an inorganic electroluminescent device.

12. A display having the area light apparatus according to claim 10, **characterized in that** the area light apparatus functions as a backlight.

13. An area light apparatus **being characterized by** the optical device according to any one of claims 1 to 9, and an area light-emitting device having a light extracting surface,
wherein the optical device is provided at a side of the light extracting surface, wherein the area light-emitting device has an isotropic light emission property and a reflection property, and wherein the number of luminous fluxes in a range no less than 30° and no more than 60° with respect to the normal to the light extracting surface is greater than the number of luminous fluxes in other directions.

14. The area light apparatus according to claim 13,
**characterized in that** the area light-emitting device is an organic electroluminescent device or an inorganic electroluminescent device.

15. A display having the area light apparatus according to claim 13, **characterized in that** the area light apparatus functions as a backlight.

16. An optical device for changing an optical path of light that reaches the device,
wherein the optical device is transparent, the optical device comprising an incident surface and a light exit surface located at an opposite side from the incident surface, wherein the light exit surface defines a plurality of projections and/or recesses, the projections projecting away from the incident surface, and the recesses being dented toward the incident surface, the optical device being **characterized in that**:

sections of the light exit surface that define projections and/or recesses include side faces of cones or truncated cones, each of the cones and the truncated cones having a bottom that is an imaginary plane substantially parallel to the incident surface, wherein the side face of each cone or each truncated cone is inclined at a predetermined angle relative to the normal to the incident surface, wherein the predetermined angle is in a range greater than 30° and less than 55°.

17. The optical device according to claim 16,
**characterized in that** the predetermined angle is in a range greater than 42.5° and less than 55°.

18. The optical device according to claim 16,
**characterized in that** the projections or the recesses are arranged such that the bottom of each cone contacts the bottom of an adjacent cone.

19. The optical device according to claim 16,
**characterized in that** the projections or the recesses are arranged such that the bottom of each truncated cone contacts the bottom of an adjacent truncated cone.

20. An area light apparatus **being characterized by** the optical device according to any one of claims 16 to 19, and an area light-emitting device having an isotropic light emission property, wherein the area light-emitting device includes a light extracting surface, and wherein the optical device is provided at a side of the light extracting surface, and
wherein the area light-emitting device includes a reflection property to reflect light from the optical device toward the optical device.

21. The area light apparatus according to claim 20,
**characterized in that** the area light-emitting device is an organic electroluminescent device or an inorganic electroluminescent device.

22. A display having the area light apparatus according to claim 20 or 21, **characterized in that** the area light apparatus functions as a backlight.

23. An area light apparatus **being characterized by** the optical device according to any one of claims 16 to 19, and an area light-emitting device having a light extracting surface,
wherein the optical device is provided at a side of the light extracting surface, wherein the area light-emitting device has an isotropic light emission property and a reflection property, and wherein the number of luminous fluxes in a range no less than 30° and no more than 60° with respect to the normal to the light extracting surface is greater than the number of luminous fluxes in other directions.

24. The area light apparatus according to claim 23,

**characterized in that** the area light-emitting device is an organic electroluminescent device or an inorganic electroluminescent device.

25. A display having the area light apparatus according to claim 23 or 24, **characterized in that** the area light apparatus functions as a backlight.

# Fig.1

# Fig.2

Fig.2(b)

Fig.2(a)

# Fig.3

Fig.3(b)

Fig.3(a)

# Fig.4

# Fig.5

130b

10b

110b

10a

130a

110a

130a-1

2

# Fig.6

13c

13b

13

13a

1b

θ

11

11H

# Fig.7

# Fig.8

**Fig.8(b)**

**Fig.8(a)**

# Fig.9

**Fig.9(b)**

**Fig.9(a)**

# Fig.10

**Fig.10 (b)**

**Fig.10 (a)**

# Fig.11

**Fig.11 (b)**

**Fig.11 (a)**

# Fig.12

**Fig.12(b)**

**Fig.12(a)**

# Fig.13

**Fig.14(a)**

**Fig.14(b)**

**Fig.15(a)**

**Fig.15(b)**

**Fig.16(a)**  **Fig.16(b)**

# Fig.17

# Fig.18

# Fig.19

# Fig.20

**Fig.20(b)**

Upper

Left

Right

20b

20a

20a

20b

Lower

**Fig.20(a)**

# Fig.21

Left

Right

S3

θ4

L2

S2

θ2

401b

401

θ3

θ5

401a

L1

θ1

S1

# Fig.22

25°

65°

401b

S2

37°

S1

28°

40b

n=1.50

45°

S1

401a

**European Patent Office**

# EUROPEAN SEARCH REPORT

Application Number

EP 04 01 3493

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | WO 03/046617 A (BLIESKE ULF ; DOEGE THOMAS (DE); NEANDER MARCUS (DE); BAYOUT PATRICK () 5 June 2003 (2003-06-05) | 1-9, 16-19 | G02B5/04 G02F1/1335 |
| Y | * abstract * <br><br>* page 6, line 3 - page 7, line 19 * <br>* page 9, line 31 - page 10, line 13; figures * <br>————— | 10-15, 20-25 | |
| Y | PATENT ABSTRACTS OF JAPAN vol. 2000, no. 14, 5 March 2001 (2001-03-05) -& JP 2000 323272 A (CASIO COMPUT CO LTD), 24 November 2000 (2000-11-24) * abstract; figures 1,3 * <br>————— | 10-15, 20-25 | |
| Y | US 5 798 610 A (KOENCK STEVEN E ET AL) 25 August 1998 (1998-08-25) * the whole document * <br>————— | 10-15, 20-25 | |
| X | PATENT ABSTRACTS OF JAPAN vol. 1996, no. 04, 30 April 1996 (1996-04-30) -& JP 07 318918 A (ALPS ELECTRIC CO LTD), 8 December 1995 (1995-12-08) * abstract; figures 1-3 * <br>————— | 1-7 | TECHNICAL FIELDS SEARCHED (Int.Cl.7) <br><br>G02B <br>G02F |
| X | EP 1 122 559 A (NAKANE CO LTD) 8 August 2001 (2001-08-08) * paragraphs '0011!, '0012!, '0020!, '0021!, '0041!, '0042!; figures 2,3,7,8 * <br>————— <br>-/-- | 1-3,6,7 | |

The present search report has been drawn up for all claims

| Place of search | Date of completion of the search | Examiner |
|---|---|---|
| The Hague | 7 October 2004 | Cohen, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 04 01 3493

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 417 831 B2 (KASHIMA KEIJI) 9 July 2002 (2002-07-09) | 1,2,6 | |
| A | * abstract * * column 2, line 13 - line 32 * * column 4, line 1 - line 15 * * column 7, line 41 - line 53; figures 1,2,8-10 * | 16 | |
| P,X | WO 2004/017106 A (ZEON CORP ; KUSANO KENJI (JP); KASHIWAGI MOTOFUMI (JP)) 26 February 2004 (2004-02-26) * abstract * * page 2, line 1 - line 4 * * page 6, line 20 - line 21; figures * | 1-6,8, 10-12 | |
| A | US 2002/163728 A1 (MYERS KENNETH J) 7 November 2002 (2002-11-07) * abstract * * paragraphs '0008!, '0019! - '0021!; figures * | 1,2, 6-11,16, 18-21,24 | TECHNICAL FIELDS SEARCHED (Int.Cl.7) |

The present search report has been drawn up for all claims

| Place of search | Date of completion of the search | Examiner |
|---|---|---|
| The Hague | 7 October 2004 | Cohen, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 04 01 3493

This annex lists the patent family members relating to the patent documents cited in the above-mentioned European search report.
The members are as contained in the European Patent Office EDP file on
The European Patent Office is in no way liable for these particulars which are merely given for the purpose of information.

07-10-2004

| Patent document cited in search report | | Publication date | Patent family member(s) | | Publication date |
|---|---|---|---|---|---|
| WO 03046617 | A | 05-06-2003 | FR<br>EP<br>WO | 2832811 A1<br>1449017 A1<br>03046617 A1 | 30-05-2003<br>25-08-2004<br>05-06-2003 |
| JP 2000323272 | A | 24-11-2000 | NONE | | |
| US 5798610 | A | 25-08-1998 | US | 5673999 A | 07-10-1997 |
| JP 07318918 | A | 08-12-1995 | TW | 406200 B | 21-09-2000 |
| EP 1122559 | A | 08-08-2001 | JP<br>EP | 2001208903 A<br>1122559 A2 | 03-08-2001<br>08-08-2001 |
| US 6417831 | B2 | 18-10-2001 | JP<br>US | 10246805 A<br>2001030638 A1 | 14-09-1998<br>18-10-2001 |
| WO 2004017106 | A | 26-02-2004 | WO | 2004017106 A1 | 26-02-2004 |
| US 2002163728 | A1 | 07-11-2002 | US<br>TW<br>WO<br>US<br>US | 6443579 B1<br>531663 B<br>02091033 A2<br>2002163729 A1<br>6609799 B1 | 03-09-2002<br>11-05-2003<br>14-11-2002<br>07-11-2002<br>26-08-2003 |

EPO FORM P0459

For more details about this annex : see Official Journal of the European Patent Office, No. 12/82